# EUROPEAN PATENT SPECIFICATION

(11) **EP 2 450 397 B1**
(45) Date of publication and mention of the grant of the patent: **17.06.2015**
(21) Application number: 11178803.0
(22) Date of filing: 25.08.2011
(51) Int. Cl.: C08J 7/04, C08J 7/12, H01L 31/04, B32B 27/28

(54) **Solar cell protective sheet and its production method, backsheet for solar cell, and solar cell module**
Solarzellenschutzschirm und Herstellungsverfahren dafür, Solarzellenrückseite und Solarzellenmodul
Feuille protectrice de cellule solaire et son procédé de production, couche de support pour cellule solaire et module de cellule solaire

(30) Priority: 26.08.2010 JP 2010189958; 24.09.2010 JP 2010213786
(43) Date of publication of application: 09.05.2012
(73) Proprietor: FUJIFILM Corporation, Tokyo 106-8620 (JP)
(72) Inventor: Aritoshi, Yohei, Kanagawa, 258-8577 (JP); Suzuki, Ryota, Kanagawa, 258-8577 (JP); Akasaki, Yusuke, Kanagawa, 258-8577 (JP); Oda, Toshihiro, Kanagawa, 258-8577 (JP); Hatakeyama, Akira, Kanagawa, 258-8577 (JP)
(74) Representative: Hoffmann Eitle

(56) References cited:
- EP-A2- 1 046 667
- WO-A1-2009/067422
- WO-A1-2009/126115
- JP-A- 9 132 716
- JP-A- 2008 189 828

## Description

### BACKGROUND OF THE INVENTION

### Field of the Invention

The present invention relates to a solar cell protective sheet and its production method, and to a backsheet for solar cells that is provided on the side opposite to the sunlight incident side of a solar cell element, as well as to a solar cell module.

### Description of the Related Art

A solar cell module is generally so designed that a solar cell element is sandwiched between the front side substrate on which sunlight falls (that is, front side glass, transparent polymer, etc.), and the backsheet arranged on the side (back side) opposite to the sunlight incident side, in which the space between the front side substrate and the solar cell element and the space between the solar cell element and the backsheet each are sealed up with a sealant such as an EVA (ethylene-vinyl acetate) resin or the like.

The front side substrate and the backsheet each serve as a solar cell protective sheet for protecting the solar cell module from penetration of water through the surface or the back thereof. For the solar cell protective sheet, heretofore used is glass, fluororesin or the like; however, recently, a polymer sheet, for example, a polyester resin sheet or the like has become used from the viewpoint of the cost thereof. The solar cell protective sheet is exposed to direct contact with water, heat and light, and therefore, the adhesiveness between the solar cell protective sheet and the sealant is desired' to satisfy long-term durability under high-temperature and high-humidity conditions. However, conventional solar cell protective sheets are unsatisfactory in point of the adhesiveness between the solar cell protective sheet and the sealant, from the viewpoint of the long-term durability thereof under high-temperature and high-humidity conditions. Accordingly, at present, enhancing the durability of solar cells under wet heat environments is strongly desired.

On the other hand, recently, especially the backsheet of the solar cell protective sheet is desired to be given other various functions such as those mentioned below in addition to the function of protecting the solar cell module from penetration of water into the back thereof, as a mere single-layer polymer sheet such as a polyester resin sheet or the like.

Regarding the desired functions, for example, white inorganic fine particles of titanium oxide or the like are added to the backsheet to thereby make the backsheet have light reflectability. This is to diffusively reflect the light fraction of the incident sunlight, which has entered the module through the front side thereof and which has passed through the cell, and to return the light to the cell thereby enhancing the power generation efficiency. Regarding this, an example of a white polyethylene terephthalate film with white inorganic fine particles added thereto is disclosed (for example, see Patent References 1, 3) ; and an example of a backside protective sheet having a white pigment-containing white ink layer is also disclosed (for example, see Patent Reference 3). Further, for securing firm adhesiveness between the backsheet and the EVA sealant, a polymer layer such as an easy adhesion layer or the like may be arranged as the outermost layer of the backsheet. Regarding this, a technique of providing a thermal adhesive layer on a white polyethylene terephthalate film is described (for example, see Patent Reference 1).

For giving the above-mentioned functions thereto, the backsheet is so designed that the substrate polymer thereof is laminated with various functional layers having such other functions. Accordingly, recently, even inside the solar cell protective sheet, the durability under wet heat environments of the interlayer adhesion force between the substrate (support) and various functional layers thereon is desired to be improved.

In this, as the means for lamination, there is known a method of sticking sheets having various functions to a substrate polymer, and for example, there is disclosed a method of forming a solar cell back sheet through lamination of multiple resin films (for example, see Patent Reference 2). However, lamination of multiple resin films is poor in the interlayer adhesiveness in long-term use under wet heat environments, and is therefore insufficient in point of the durability of the laminate. Also for forming a solar cell backsheet, there is disclosed another method of coating a substrate polymer with various functional layers (for example, see Patent References 3 and 4). Also known is a method of surface-treating the substrate polymer prior to forming coating layers thereon (for example, see Patent References 4 and 5). Patent References 4 and 5 disclose that, when a polysiloxane resin such as a fluorosilicone resin or a modified silicon compound is added to the coating liquid, then the washability, the water drainablity, the antifogging property, the antidewing property, the antistatic property and the biocompatibility of the sheet can be improved; however, in these, nothing is investigated relating to the wet heat durability of the sheet.

### Citation List

Patent Reference 1: JP-A 2003-060218
Patent Reference 2: JP-A 2002-100788
Patent Reference 3: JP-A 2006-210557
Patent Reference 4: JP-A 2008-189828
Patent Reference 5: JP-A 2000-301054

### SUMMARY OF THE INVENTION

However, the present inventors investigated the wet heat durability of the sheets described in Patent References 4 and 5, and have found that the interlayer adhesiveness inside the solar cell protective sheet and the adhesiveness between the solar cell protective sheet and the sealant still could not be secured in long-term use under wet heat environments, and therefore the sheets require further improvement.

The present invention has been made in consideration of the above, and the problem that the invention is to solve is to provide a solar cell protective sheet excellent in adhesiveness durability in wet heat environments.

The present inventors have assiduously studied and, as a result, have found that surface treatment of the polymer substrate and use of a coating liquid that contains a composite polymer containing a polysiloxane structural unit and a non-polysiloxane structural unit and differing from the polymer in Patent Reference 5 in that the composite polymer has a non-polysiloxane structural unit could contribute toward improving the adhesiveness in wet heat environments. Further, the inventors tried significantly increasing the coating thickness after drying of the coating liquid that contains a composite polymer containing a polysiloxane structural unit and a non-polysiloxane structural unit, as compared with the thickness described in Patent Reference 4, and have found that, as a result, the interlayer adhesiveness inside the solar cell protective sheet and the adhesiveness between the solar cell protective sheet and a sealant can be thereby significantly improved under wet heat environments. Specifically, the inventors have found that the above-mentioned problems can be solved by the following constitution, and have completed the present invention.

Concrete means for solving the above-mentioned problems are defined in the claims.

According to the invention, there is provided a solar cell protective sheet excellent in adhesiveness durability in wet heat environments.

The solar cell protective sheet of the invention is favorably used for solar cell backsheets. According to the invention, the solar cell protective sheet of the invention can be produced inexpensively. According to the invention, there is provided a solar cell module that secures long-term stable power generation efficiency in wet heat environments.

### BRIEF DESCRIPTION OF THE DRAWINGS

Fig. 1 is a schematic cross-sectional view showing a configuration example of a solar cell module.
Fig. 2 is a schematic cross-sectional view showing another configuration example of a solar cell module.

In the drawings, 5 and 5a each indicate a solar cell backsheet; 10 indicates a solar cell module; 12 indicates a fluoropolymer layer; 14 indicates an undercoat layer; 16 indicates a polymer substrate; 18 indicates a reflection layer; 20 indicates a solar cell element; 22 indicates a sealant; and 24 indicates a transparent substrate.

### MODE FOR CARRYING OUT THE INVENTION

The solar cell protective sheet and its production method of the invention, and the solar cell backsheet and the solar cell module of the invention are described in detail hereinunder.

The description of the constitutive elements of the invention given hereinunder, is for some typical embodiments of the invention, to which, however, the invention should not be limited. In this description, the numerical range expressed by the wording "a number to another number" means the range that falls between the former number indicating the lowermost limit of the range and the latter number indicating the uppermost limit thereof.

In the following, the solar cell protective sheet satisfying the condition [1] (solar cell protective sheet of the invention) is described.

### Solar Cell Protective Sheet Satisfying the Condition [1]

The solar cell protective sheet satisfying the condition [1] (referred to as the solar cell protective sheet of the invention) comprises a surface-treated polymer substrate and, as provided on the polymer substrate, at least one polymer layer having a thickness of from 0.8 µm to 12 µm and containing a composite polymer, in which the composite polymer contains a polysiloxane structural unit represented by the following formula (1) and a non-polysiloxane structural unit in the molecule: 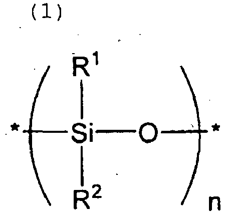 wherein R¹ and R² each independently represent a hydrogen atom, a halogen atom or a monovalent organic group; n indicates an integer of 1 or more; R¹ and R² may be the same or different; plural R¹'s may be the same or different, and plural R²', may be the same or different.

In the invention, (i) the polymer substrate is surface-treated, (ii) at least one polymer layer containing a composite polymer has a controlled thickness of from 0.8 to 12 µm, and (iii) the composite polymer is a specific composite polymer containing a polysiloxane structural unit represented by the above-mentioned formula (1) and a non-polysiloxane structural unit in the molecule, whereby the adhesion force to the polymer substrate is enhanced and the degradation by heat and moisture can be inhibited. Accordingly, in an environmental condition where the sheet is exposed to heat and moisture for a long period of time, the adhesion strength between the polymer substrate and the composite polymer-containing polymer layer can be kept high for a long period of time, therefore securing long-term durability of the sheet. In case where the sealant such as EVA of a solar cell module is stuck to the solar cell protective sheet of the invention, the adhesion strength between the solar cell protective sheet and the sealant can be kept high for a long period of time even in an environmental condition where the module is exposed to heat and moisture for a long period of time. Accordingly, The solar cell module constructed according to the invention can exhibit good power generation performance and can secure stable power generation efficiency for a long period of time.

The details and the preferred embodiments of the solar cell protective sheet of the invention are described below.

### <Polymer Substrate>

### (Type of Polymer)

The type of polymer for use for the polymer substrate includes polyester, polyolefin such as polypropylene and polyethylene, and fluoropolymer such as polyvinyl fluoride, etc. Of those, preferred is polyester from the viewpoint of the cost and the mechanical strength thereof.

The polyester to be used as the polymer substrate (support) is a linear saturated polyester produced from an aromatic dibasic acid or an ester-forming derivative thereof, and a diol or an ester-forming derivative thereof. Specific examples of the polyester include polyethylene terephthalate, polyethylene isophthalate, polybutylene terephthalate, poly(1,4-cyclohexylenedimethylene terephthalate), polyethylene 2, 6-naphthalate, etc. Of those, especially preferred is polyethylene terephthalate or polyethylene 2,6-naphthalate from the viewpoint of the balance of the mechanical properties and the cost thereof.

The polyester may be a homopolymer, or a copolymer. Further, the polyester may be blended with a small amount of any other resin, for example, a polyimide or the like.

In producing the polyester through polymerization in the invention, preferably used is an Sb-containing, Ge-containing or Ti-containing compound as the catalyst, from the viewpoint of controlling the carboxyl group content of the polymer to be lower than a predetermined range; and more preferred is use of a Ti-containing compound. Preferably, the amount of the Ti-containing compound, when used as the catalyst for polymerization in one embodiment, is within a range of from 1 ppm to 30 ppm, more preferably from 3 ppm to 15 ppm. When the proportion of the Ti-containing compound falls within the range, then the terminal carboxyl group content of the formed polymer can be controlled to fall within the range mentioned below, whereby the hydrolysis resistance of the polymer substrate may be kept high.

In producing the polyester with a Ti-containing compound, for example, usable are the methods described in JP-B 8-301198, Japanese Patent 2543624, 3335683, 3717380, 3897756, 3962226, 3979866, 3996871, 4000867, 4053837, 4127119, 4134710, 4159154, 4269704, 4313538, etc.

In the invention, preferably, the polymer substrate contains a polyester resin and the carboxyl group content of the polyester is at most 55 equivalent/t, more preferably at most 35 equivalent/t. When the carboxyl group content is at most 55 equivalent/t, then the polymer substrate can secure good hydrolysis resistance and its strength reduction in aging under wet heat can be retarded. The lowermost limit of the carboxyl group content is preferably 2 equivalent/t from the viewpoint of securing the adhesiveness between the polyester substrate and the layer formed adjacent thereto (for example, colorant layer). Specifically in the invention, it is especially desirable that the carboxyl group content of the polyester resin is from 2 to 35 equivalent/t.

The carboxyl group content of the polyester may be controlled by suitably selecting the type of the polymerization catalyst and the film formation condition (film formation temperature and time).

Preferably, the polyester in the invention is solid-phase polymerized after polymerization. Accordingly, the polyester can have the desired carboxyl group content. The solid-phase polymerization may be attained according to a continuous method (where the resin is charged in a tower, then gradually refluxed with heating therein for a predetermined period of time, and then taken out), or according to a batch method (where the resin is put into a chamber and heated for a predetermined period of time). Concretely, for the solid-phase polymerization, employable are the methods described in Japanese Patent 2621563, 3121876, 3136774, 3603585, 3616522, 3617340, 3680523, 3717392, 4167159, etc.

Preferably, the solid-phase polymerization temperature is from 170°C to 240°C, more preferably from 180°C to 230°C, even more preferably from 190°C to 220°C. Preferably, the solid-phase polymerization time is from 5 hours to 100 hours, more preferably from 10 hours to 75 hours, even more preferably from 15 hours to 50 hours. Preferably, the solid-phase polymerization is attained in vacuum or in a nitrogen atmosphere.

Preferably, the polyester substrate is a biaxially-stretched film that is prepared by melt-extruding the above-mentioned polyester into a film, then cooled and solidified on a casting drum to be an unstretched film, stretching the unstretched film at Tg to (Tg + 60)°C in the machine direction once or more to a total draw ratio of from 3 times to 6 times, and thereafter further stretching it in the cross direction at Tg to (Tg + 60)°C to a draw ratio of from 3 to 5 times. If desired, the film may be heat-treated at 180 to 230°C for 1 to 60 seconds.

Preferably, the thickness of the polymer substrate (especially polyester substrate) is from 25 to 300 µm or so. When the thickness is at least 25 µm, then the substrate may have good mechanical strength; and when at most 300 µm, the substrate is advantageous in point of the cost thereof.

In particular, with the increase in the thickness thereof, the hydrolysis resistance of the polyester substrate may worsen and the substrate could not be resistant to long-term use; and in the invention, when the thickness of the substrate is from 120 µm to 300 µm and the carboxyl group content of the polyester is from 2 to 35 equivalent/t, the wet heat durability of the substrate is enhanced.

### (Surface Treatment)

The method of surface treatment of the polymer substrate is not specifically defined. In the invention, preferred examples of the surface treatment for the polymer substrate are flame treatment, low-pressure plasma treatment, atmospheric pressure plasma treatment, ultraviolet treatment, etc. Of those, in the invention, more preferred is atmospheric pressure plasma treatment from the viewpoint of the cost thereof and from the mechanical strength of the treated substrate.

The surface treatment enhances the adhesiveness between the polymer substrate to be a support and the composite polymer-containing polymer layer to be mentioned below, or that is, the treatment enhances the peeling resistance and the shape stability of the substrate that may be worsened when given heat or moisture, more significantly than before.

### (1) Flame Treatment:

The flame treatment is a treatment method of contacting the support with an outer flame. In general, a flame is formed with a burner and the flame is applied to the surface of the support for the treatment.

Not specifically defined, the flame treatment burner for use in the invention may be any one capable of uniformly applying its flame to the surface of the polymer substrate. A plurality of round burners may be arranged uniformly in the widthwise direction, or a horizontally-long slit box burner of which the width is the same as or longer than the width of the polymer substrate may also be used. In case where a web-like polymer substrate is treated, a plurality of those round burners or horizontally-long slit box burners may be arranged in the web-traveling direction.

The flame treatment may be attained on a back roll, or may be attained in a roll-free space between two rolls; but in the invention, the flame treatment is preferably attained on a back roll.

In case where the flame treatment is attained on a back roll, preferably, the back roll is a cooling back roll. Preferably, the temperature of the cooling back roll is controlled to fall between 10°C and 100°C, more preferably between 25°C and 60°C. When the temperature of the cooling roll is lower than 10°C, dewing may occur; but when higher than 100°C, the support may deform.

The material of the back roll for use for the flame treatment may be any and every heat-resistant material, but in the invention, preferred are metals or ceramics. The metals include iron, chrome-plated iron, SUS 304, 316, 420, etc. Apart from these, also usable are ceramics such as alumina, zirconia, silica, etc.

As the combustion gas for use for the flame treatment, useful is paraffin gas (e.g., town gas, natural gas, methane gas, ethane gas, propane gas, butane gas), olefin gas (ethylene gas, propylene gas), or acetylene gas. One or more different types of those gases may be used here.

In the invention, the oxidizing gas to be mixed with the combustion gas for the flame treatment is preferably oxygen or air, and if desired, a combustion promoter or an oxidizing agent may also be used.

Not specifically defined, the flame for the treatment may be ordinary flame, and apart from it, also preferred is a method of using a silicate flame by adding a silane compound to a fuel as described in Japanese Patent 3893394 or JP-A 2007-39508.

The mixing ratio of the combustion gas and the oxidizing gas in the flame treatment may vary depending on the type of the gas; and for example, in a case of propane gas and air, the mixing ratio of propane gas/air is preferably from 1/15 to 1/22 by volume, more preferably from 1/16 to 1/19. In a case of natural gas and air, the ratio is preferably from 1/6 to 1/10, more preferably from 1/7 to 1/9.

In the invention, the polymer substrate may be flame-treated only on one surface thereof, but may be on both surfaces thereof.

In the invention, the time for which the polymer substrate is exposed to flame, or that is, the time for which the web passes through an effective flame area is preferably from 0.001 seconds to 2 seconds, more preferably from 0.01 seconds to 1 second. When the time is shorter than 2 seconds, the web surface is hardly damaged and hardly loses its adhesive ability. When longer than 0.001. seconds, the oxidation reaction easily occurs and to contribute toward improving the adhesiveness of the substrate surface.

### (2) Low-Pressure Plasma Treatment:

The low-pressure plasma treatment is a method of treating the surface of the substrate by generating plasma through discharging in a low-pressure atmosphere gas (plasma gas).

As the plasma gas, usable is an inorganic gas such as oxygen gas, nitrogen gas, water vapor gas, argon gas, helium gas, etc. Especially preferred is oxygen gas, or a mixed gas of oxygen gas and argon gas. Concretely, in the invention, a mixed gas of oxygen gas and argon gas is preferably used. In case where oxygen gas and argon gas are used, the ratio of the two is preferably, as a partial pressure of oxygen gas/argon gas, from 100 to 0 to 30/70 or so, more preferably from 90/10 to 70/30 or so.

The pressure of the plasma gas is preferably within a range of from 0.005 to 10 Torr, more preferably from 0.008 to 3 Torr or so. When the pressure of the plasma gas is at least 0.005 Torr, then the adhesiveness-improving effect may be satisfactory; but on the contrary, when at most 10 Torr, then the current does not increase too much and the discharging.may be kept stable.

The plasma output power is preferably from 100 to 2500 W or so, more preferably from 500 to 1500 W or so.

The processing time is preferably from 0.05 to 100 seconds, more preferably from 0.5 to 30 seconds or so. When the processing time is at least 0.05 seconds, the adhesiveness-improving effect may be satisfactory; but on the contrary, when at most 100 seconds, then the support is free from problem of deformation or discoloration.

In the low-pressure plasma treatment, the method of generating plasma is not specifically defined. In the invention, for example, employable is an apparatus of direct current glow discharging, high-frequency discharging, microwave discharging or the like. In particular, a method of using a high-frequency discharging apparatus at 3.56 MHz is favorable here.

### (3) Atmospheric Pressure Plasma Treatment:

The atmospheric pressure plasma treatment is a method of generating stable plasma discharging under atmospheric pressure by the use of high frequency.

For the atmospheric pressure plasma, the carrier gas is preferably argon gas, helium gas or the like partially mixed with oxygen or the like, and more preferred is a mixture of air and argon gas.

Preferably, the atmospheric pressure plasma treatment is attained under atmospheric pressure or therearound under a pressure of from 500 to 800 Torr or so, more preferably from 600 to 750 Torr.

Preferably, the power source frequency for the discharging is from 1 to 100 kHz, more preferably from 1 to 10 kHz or so. When the power source frequency is at least 1 kHz, then stable discharging may be attained favorably. On the contrary, when at most 100 kHz, any expensive apparatus is not needed and the method is favorable from the viewpoint of the producibility and the cost thereof.

Not specifically defined, the discharging intensity in the atmospheric pressure plasma treatment is, in the invention, preferably from 50 W·min/m² to 500 W·min/m² or so. When the discharging intensify in the atmospheric pressure plasma treatment is at most 500 W·min/m², arc discharging hardly occurs and stable atmospheric pressure plasma treatment may be attained. When at least 50 W·min/m², a sufficient surface treatment effect can be attained.

The treatment time is preferably from 0.05 to 100 seconds, more preferably from 0.5 to 30 seconds or so. When the treatment time is at least 0.05 seconds, then the adhesiveness-improving effect may be satisfactory, but on the contrary, when at most 100 seconds, the support is free from problem of deformation or discoloration.

The method of generating plasma may be the same as that for low-pressure plasma treatment.

### (4) Ultraviolet Treatment:

The ultraviolet treatment comprises irradiating the sample surface with ultraviolet rays to thereby improve the adhesiveness, the wettability, the printability and the like thereof.

As the ultraviolet source, generally used is a low-pressure mercury lamp (low-pressure mercury UV lamp). The ultraviolet rays at 254 nm and 185 nm from the low-pressure ultraviolet lamp, especially the latter ray is effective for the intended surface treatment.

The ultraviolet treatment is attained generally under atmospheric pressure for 1 to 500 seconds. When the treatment time is at least 1 second, the adhesiveness improving effect may be satisfactory, but on the contrary, when at most 500 seconds, the substrate polymer is free from problem of discoloration or the like.

### <Composite Polymer-Containing Polymer Layer>

The composite polymer-containing polymer layer is a layer to be arranged in contact with the surface of the polymer substrate or arranged thereon via any other layer, and is formed of a specific composite polymer. In the invention, the adhesiveness of the composite polymer layer to the surface-treated polymer substrate is enhanced, and therefore preferably, the polymer layer is formed directly on the polymer substrate. Specifically, it is desirable that at least one, composite polymer-containing polymer layer is formed on the polymer substrate to be in direct contact with the surface-treated surface of the substrate.

The composite polymer-containing polymer layer is applicable to any desired layer constituting the solar cell protective sheet of the invention. For example, the polymer layer may be applicable as the reflection layer or the back layer to be mentioned below of the solar cell backsheet of the invention. As excellent in durability under wet heat environments where it is exposed to heat and moisture, the polymer layer is especially preferably used as the back layer of constituting the backsheet, which is, in a solar cell module where a solar cell element is encapsulated with a sealant, directly exposed to external environments on the side opposite to the side of the cell-side substrate sealed up with the sealant.

The composite polymer-containing polymer layer may comprise, if desired, any other component, and its constitutive composition varies depending on the use thereof. The composite polymer-containing polymer layer may be a colorant layer having a sunlight-reflective function or having an outward appearance designing ability, or may be a back layer to be arranged on the side opposite to the sunlight-incident side.

In case where the composite polymer-containing polymer layer is a reflection layer for reflecting, for example, sunlight toward the incident side, a colorant such as a white pigment or the like may be added thereto.

In the solar cell protective sheet of the invention, the composite polymer-containing polymer layer contains the composite polymer as mentioned above, in which the composite polymer itself is excellent in deterioration resistance (adhesiveness durability) under wet heat environments.

Accordingly, in the invention, it is desirable that at least one, composite polymer-containing polymer layer is arranged as the outermost layer in the position remotest from the polymer substrate, and more preferably, the layer is the outermost layer arranged in the position not in contact with the surface of the polymer substrate. Concretely, for example, the polymer layer is the back layer to be arranged on the opposite side (back) to the side (front) facing the cell-side substrate having a solar cell element formed thereon, or the light-reflective layer to be arranged so as to be in contact with the sealant of encapsulating the solar cell element on the cell-side substrate.

### (Composite Polymer)

The composite polymer-containing polymer layer contains at least one composite polymer mentioned above, which contains a polysiloxane structural unit represented by the following formula (1) and a non-polysiloxane structural unit in the molecule : 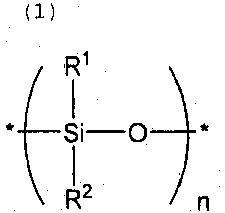 wherein R¹ and R² each independently represent a hydrogen atom, a halogen atom or a monovalent organic group; n indicates an integer of 1 or more; R¹ and R² may be the same or different; plural R¹'s may be the same or different, and plural R²'s may be the same or different.

Containing the composite polymer, the polymer layer is exponentially more improved than before, in point of the long-term adhesiveness durability to the surface-treated polymer substrate serving as the support, under wet heat environments, or that is, in point of the peeling resistance and the shape stability of the layer that may be readily worsened when given heat or moisture.

The composite polymer is a copolymer formed through copolymerization of a polysiloxane structural unit represented by the above-mentioned formula (1) and a non-polysiloxane structural unit, and may be a block copolymer or a random copolymer. Preferably, the composite polymer is a block copolymer. Each one alone or two or more different types of the polysiloxane structural unit represented by the formula (1) and the nbn-polysiloxane structural unit to be copolymerized with it may be used here, each either singly or as combined.

Preferably, the polysiloxane structural unit represented by the formula (1) is a polysiloxane segment derived from various types of polysiloxanes, having a linear, branched or cyclic structure.

Preferred embodiments of the polysiloxane structural unit represented by the formula (1) in the composite polymer are described below.

R¹ and R² each independently represent a hydrogen atom, a halogen atom or a monovalent organic group.

The halogen atom represented by R¹ and R² includes a fluorine atom, a chlorine atom, an iodine atom, etc.

The monovalent organic group is preferably a monovalent organic group capable of covalent-bonding to the Si atom.

The "monovalent organic group capable of covalent-bonding to the Si atom" represented by R¹ and R² may be unsubstituted or may have a substituent, and includes, for example, an alkyl group (e. g. , methyl group, ethyl-group, etc.), an aryl group (e.g., phenyl group, etc.), an aralkyl group (e.g., benzyl group, phenylethyl group, etc.), an alkoxy group (e.g., methoxy group, ethoxy group, propoxy group, etc.), an aryloxy group (e.g., phenoxy group, etc.), a mercapto group, an amino group (e.g., amino group, diethylamino group, etc.), an amide group, etc.

Above all, it is desirable that R¹ and R² each are independently a hydrogen atom, a chlorine atom, a bromine atom, an unsubstituted or substituted alkyl group having from 1 to 4 carbon atoms (especially, methyl group, ethyl group), an unsubstituted or substituted alkoxy group (especially, methoxy group, ethoxy group, propoxy group), an unsubstituted or substituted phenyl group, a mercapto group, an unsubstituted amino group or an amide group, from the viewpoint of the adhesiveness of the polymer to the polymer substrate and of the durability thereof under wet heat environments. More preferably, R¹ and R² each are independently a substituted or unsubstituted alkoxy group, even more preferably an unsubstituted alkoxy group having from 1 to 4 carbon atoms, from the viewpoint of the durability of the polymer under wet heat environments.

Preferably, n is from 1 to 5000, more preferably from 1 to 1000.

In the invention, the proportion of the polysiloxane structural unit of the formula (1) may be from 15 to 85% by mass of the entire molecule of the composite polymer, preferably from 20 to 80% by mass from the viewpoint of the adhesiveness of the polymer to the polymer substrate and of the durability thereof under wet heat environments.

When the proportion of the polysiloxane structural unit is at least 15% by mass, the adhesiveness of the polymer to the polymer substrate and the adhesiveness durability thereof exposed to wet heat environments may be bettered; and when at most 85% by mass, the coating liquid of the polymer may be stable.

The non-polysiloxane structural unit to copolymerize with the polysiloxane structural unit segment of the formula (1) in the composite polymer is not specifically defined except that the non-polysiloxane structural unit copolymerizes with the recurring unit, and may be a polymer segment derived from any polymer. As the polymer that is a precursor of the polymer segment (precursor polymer), for example, preferred are various polymers such as a vinylic polymer, a polyester polymer, a polyurethane polymer, etc. Specifically, in the invention, the non-polysiloxane structural unit is preferably at least one of a vinyl-type structural unit, a polyester-type structural unit and a polyurethane-type structural unit. In other words, in the invention, the non-polysiloxane structural unit in the composite polymer is preferably at least one of a vinyl-type structural unit, a polyester-type structural unit and a polyurethane-type structural unit. From the viewpoint of easy producibility and excellent hydrolysis resistance of the composite polymer, more preferred are vinylic polymers and polyurethane polymers.

Specific examples of the vinylic polymers include various polymers such as acrylic polymers, vinyl carboxylate polymers, aromatic vinylic polymers, fluoro-olefinic polymers. Above all, more preferred are acrylic polymers from the viewpoint of the broad latitude in designing the composite polymer.

One alone or two or more different types of polymers to constitute the non-polysiloxane structural unit may be used here either singly or as combined.

Preferably, the precursor polymer to give the non-polysiloxane structural unit has at least one acid group or neutralized acid group and/or a hydrolyzable silyl group. Of the precursor polymer of the type, the vinylic polymer may be produced according to various methods" for example, according to (1) a method of copolymerizing an acid group-containing vinylic monomer and a vinylic monomer containing a hydrolyzable silyl group and/or silanol group, with a monomer copolymerizable with it, (2) a method of reacting a previously-prepared vinylic polymer containing a hydroxyl group and a hydrolyzable silyl group and/or silanol group, with a polycarboxylic acid anhydride, or (3) a method of reacting a previously-prepared vinylic polymer containing an acid anhydride group and a hydrolyzable silyl group and/or silanol group, with an active hydrogen-having compound (water, alcohol, amine, etc.), etc.

The precursor polymer may be produced and available, for example, according to the method described in JP-A 2009-52011, paragraphs [0021] to [0078].

The polymer layer containing the composite polymer may contain the composite polymer alone as a binder, or may be combined with any other polymer. In case where an additional polymer is used along with the composite polymer, the proportion of the composite polymer is preferably at least 30% by mass of all the binder, more preferably at least 60% by mass. When the proportion of the composite polymer is at least 30% by mass, the adhesiveness of the polymer layer to the polymer substrate and the durability thereof under wet heat environments may be excellent.

Preferably, the molecular weight of the composite polymer is from 5000 to 100,000, more preferably from 10,000 to 50,000.

### (Preparation of Composite Polymer)

For preparing the composite polymer, employable are various methods, for example, (i) a method of reacting the precursor polymer of a non-polysiloxane structural unit, with a specific polysiloxane having the polysiloxane structural unit of the formula (1), (ii) a method of hydrolytically condensing a silane compound having a structure of the polysiloxane structural unit of the formula (1) wherein R¹ and/or R² each are a hydrolyzable group, in the presence of the precursor polymer of a non-polysiloxane structural unit, etc.

The silane compound to be used in the method (ii) includes various types of silane compounds, and' is preferably an alkoxysilane compound.

In case where the composite polymer is prepared according to the method (i), for example, water and a catalyst are optionally added to a mixture of the precursor polymer and a polysiloxane, and reacted at a temperature of from 20 to 150°C for from 30 minutes to 30 hours or so (preferably at 50 to 130°C for 1 to 20 hours), thereby giving the intended composite polymer. As the catalyst, usable are various types of silanol condensation catalysts such as acid compounds, basic compounds, metal-containing compounds, etc.

In case where the composite polymer is prepared according to the method (ii), for example, water and a silanol condensation catalyst are added to a mixture of the precursor polymer and an alkoxysilane compound, and reacted for hydrolytic condensation at a temperature of from 20 to 150°C for from 30 minutes to 30 hours or so (preferably at 50 to 130°C for 1 to 20 hours), thereby giving the intended composite polymer.

### (Use as Back Layer)

In case where the composite polymer-containing polymer layer constitutes the back layer of the solar cell protective sheet of the invention, if desired, the layer may contain any other ingredient such as various additives. In a solar cell having a laminate structure, of cell-side substrate (= transparent substrate (glass substrate or the like) on the sunlight incident side)/solar cell element/solar cell backsheet, the back layer is a back-protective layer to be arranged on the side opposite to the cell-side substrate of the polymer substrate serving as a support, and the layer may have a single-layer structure or a two or more multi-layer structure.

In case where two or more back layers are provided, both or all the back layers may be the above-mentioned composite polymer-containing polymer layers, or one layer alone thereof may be the above-mentioned composite polymer-containing polymer layer. Above all, it is desirable that at least the first back layer adjacent to the polymer substrate is the above-mentioned composite polymer-containing polymer layer, from the viewpoint of enhancing the adhesiveness durability of the layer under wet heat environments.

In this case, the second back layer does not need to contain the composite polymer containing a polysiloxane structural unit of the formula (1) and a non-polysiloxane structural unit, but in such a case, preferably, the second back layer does not contain a homopolymer of polysiloxane from the viewpoint that the layer may form a uniform film layer of the resin alone with no void therein and moisture hardly penetrates into the layer via the space between the polymer resin and a white pigment, and from the viewpoint of enhancing the adhesiveness durability of the layer under wet heat environments.

Other ingredients that may be in the back layer include a crosslinking agent, a surfactant, a filler and the like that may be in the colorant layer to be mentioned below. If desired, the back layer may contain a pigment that may be in the colorant layer. The details and the preferred embodiments of the other ingredients and pigments are described below.

### (Use as Colorant Layer, Reflection Layer)

In case where the composite polymer-containing polymer layer constitutes a colorant layer (preferably, a white pigment-containing reflection layer), the layer contains a pigment in addition to the composite polymer therein. If desired, the colorant may contain any other ingredient such as various additives.

In the solar cell protective sheet of the invention, at least one, composite polymer-containing polymer layer is a light-reflective layer containing a white pigment.

As the function of the colorant layer, first mentioned is increasing the power generation efficiency of the solar cell module by reflecting the incident light, which has passed through the solar cell unit and has reached the backsheet not used for power generation, and returning it back to the solar cell unit, and secondly mentioned is improving the decorative appearance of the solar cell module seen from the sunlight incident side thereof (from the front side thereof). In general, when a solar cell module is seen from its front, the backsheet is seen around the solar cell, and by providing a colorant layer in the backsheet, the outward decoration of the solar cell module is improved.

The colorant layer may contain at least one pigment. The pigment includes, for example, inorganic pigments such as titanium oxide, barium sulfate, silicon oxide, aluminium oxide, magnesium oxide, calcium carbonate, kaolin, talc, ultramarine, prussian blue, carbon black; and organic pigments such as phthalocyanine blue, phthalocyanine green, etc. The colorant layer may contain any pigment suitably selected from these.

Of those pigments, preferred are white pigments from the viewpoint of constituting the polymer layer as the reflection layer that reflects the incident sunlight having entered the solar cell and passed through the solar cell unit, again back to the solar cell unit. As the white pigments, preferred are titanium oxide, barium sulfate, silicon oxide, aluminium oxide, magnesium oxide, calcium carbonate, kaolin, talc, etc.

Preferably, the amount of the pigment in the colorant layer is from 2.5 to 8.5 g/m². When the amount of the pigment is at least 2.5 g/m², then the layer may readily obtain the desired coloration, and the light reflectivity and the designability of the layer may be bettered. When the amount of the pigment in the colorant layer is at most 8.5 g/m², then the surface planarity of the colorant layer may be kept better an the film strength may be bettered. Above all, the pigment content is more preferably within a range of from 4.5 to 8.0 g/m².

The mean particle size of the pigment is preferably from 0.03 to 0.8 µm, more preferably from 0.15 to 0.5 µm, in terms of the volume-average particle size thereof. When the mean particle size falls within the range, then the light reflection efficiency of the pigment may be high. The mean particle, size is a value measured with a laser analytic scattering particle sizer LA950 (by Horiba Corporation).

In case where the composite polymer-containing layer constitutes a colorant layer, the content of the binder ingredient (including the above-mentioned composite polymer) therein is preferably within a range of from 15 to 200% by mass of the pigment therein, more preferably from 17 to 100% by mass. When the amount of the binder is at least 15% by mass, then the strength of the colorant layer may be kept sufficient; and when at most 200% by mass, then the reflectivity and the designability may be kept good.

### (Additives to Composite Polymer-Containing Polymer Layer)

If desired, a crosslinking agent, a surfactant, a filler and the like may be added to the composite polymer-containing polymer layer, regardless of the use of the layer as a back layer or a colorant layer.

In the invention, preferably, the composite polymer-containing polymer layer has a crosslinked structure.

Examples of the crosslinking agent are epoxy-type, isocyanate-type, melamine-type, carbodiimide-type and oxazoline-type crosslinking agents. Of those, preferred is use of oxazoline-type crosslinking agents in the invention from the viewpoint of securing the adhesiveness of the layer after aged in wet heat environments.

Examples of the oxazoline-type crosslinking agents are 2-vinyl-2-oxazoline, 2-vinyl-4-methyl-2-oxazoline, 2-vinyl-5-methyl-2-oxazoline, 2-isopropenyl-2-oxazoline, 2-isopropenyl-4-methyl-2-oxazoline, 2-isopropenyl-5-ethyl-2-oxazoline, 2,2'-bis(2-oxazoline), 2,2'-methylenebis(2-oxazoline), 2,2'-ethylenebis(2-oxazoline), 2,2'-trimethylenebis(2-oxazbline), 2,2'-tetramethylenebis(2-oxazoline), 2,2'-hexamethylenebis(2-oxazoline), 2,2'-octamethylenebis(2-oxazoline), 2,2'-ethylenebis(4,4'-dimethyl-2-oxazoline), 2,2'-p-phenylenebis(2-oxazoline), 2,2'-m-phenylenebis(2-oxazoline), 2,2'-m-phenylenebis(4,4'-dimethyl-2-oxazoline), bis(2-oxazolinylcyclohexane) sulfide, bis(2-oxazolinylnorbornane) sulfide, etc. (Co)polymers of these compounds are also preferred for use herein.

Compounds having an oxazoline group are also usable, such as Epocross K2010E, K2020E, K2030E, WS500, WS700 (all by Nippon Shokubai Kagaku Kogyo).

The amount of the crosslinking agent to be in the composite polymer-containing polymer layer is preferably from 5 to 50% by mass of the binder in the layer, more preferably from 10 to 40% by mass. When the amount of the crosslinking agent is at least 5% by mass, then the agent exhibits a good crosslinking effect, while securing the strength and the adhesiveness of the colorant layer; and when at most 50% by mass, then the pot life of the coating liquid can be kept long.

As the surfactant, herein usable are known surfactants such as anionic surfactants and nonionic surfactants. The amount of the surfactant optionally added to the layer is preferably from 0.1 to 15 mg/m², more preferably from 0.5 to 5 mg/m². When the amount of the surfactant is at least 0.1 mg/m², then the coating liquid may be free from cissing and gives a good layer; and when at most 15 mg/m², then the adhesiveness of the layer is good.

A filler may be further added to the composite polymer-containing polymer layer. The amount of the filler to be added is preferably at most 20% by mass of the binder in the layer, more preferably at most 15% by mass. When the amount of the filler is at most 20% by mass, then the surface condition of the polymer layer may be kept good.

### (Thickness of Composite Polymer-Containing Polymer Layer)

The thickness of the composite polymer-containing polymer layer in the invention may be from 0.8 µm to 12 µm, preferably from 1.0 µm to 8 µm, more preferably from 2 to 4 µm.

When the thickness is at least 0.8 µm, then moisture may hardly penetrate into the inside of the sheet through the surface of the composite polymer-containing polymer layer when exposed to wet heat environments, and moisture hardly reaches the interlayer between the polymer layer and the polymer substrate and the adhesiveness between them may be significantly enhanced. Heretofore, for example, as in JP-A 2008-189829, paragraph [0047], it is said that a silicone compound-containing coating layer preferably has a dry thickness of from 0.005 to 0.5 µm, and nothing has heretofore been investigated relating to the technique of significantly increasing the thickness of the coating layer that contains such a polysiloxane structural unit-containing composite polymer as in the present invention.

When the thickness thereof is at most 12 µm, then the composite polymer-containing polymer layer may be prevented frombecoming brittle, and when exposed to wet heat environments, the composite polymer-containing polymer layer may be prevented from being broken and the adhesiveness thereof may be thereby bettered.

### <Other Functional Layers>

The solar cell protective sheet of the invention may have any other functional layers than the above-mentioned polymer substrate and the above-mentioned composite polymer-containing polymer layer. The other functional layers includes, for example, an undercoat layer and an easy adhesion layer.

### (1) Undercoat Layer:

In the solar cell backsheet of the invention, an undercoat layer may be provided between the polymer substrate (support) and the composite polymer-containing polymer layer. The thickness of the undercoat layer is preferably within a range of at most 2 µm, more preferably from 0.05 µm to 2 µm, even more preferably from 0.1 µm to 1.5 µm. When the thickness is at most 2 µm, then the surface planarity of the sheet may be kept good. When at least 0.05 µm, then the sheet may readily secure the necessary adhesiveness.

The undercoat layer may contain a binder. As the binder, for example, usable are polyesters, polyurethanes, acrylic resins, polyolefins, etc. Apart from the binder, the undercoat layer may contain a crosslinking agent selected from epoxy-type, isocyanate-type, melamine-type, carbodiimide-type and oxazoline-type crosslinking agents, a surfactant selected from anionic and nonionic surfactants, a filler such as silica, etc.

The coating method for the undercoat layer and the solvent for the coating liquid are not specifically defined.

For example, in the coating method, a gravure coater or a bar coater may be used.

The solvent for use in the coating liquid may be water or an organic solvent such as toluene, methyl ethyl ketone, etc. One or more such solvents may be used either singly or as combined.

The coating liquid may be applied onto the polymer substrate after biaxially stretched or after monoaxially stretched, and in the latter case, the coated substrate may be further stretched in the direction different from that in which the film has been stretched previously. After the unstretched substrate is coated, it may be stretched in two directions.

### (2) Easy Adhesion Layer:

Especially in case where the solar cell protective sheet of the invention is used as the backsheet of a solar cell, an easy adhesion layer may be further provided on the composite polymer-containing polymer layer (especially the reflection layer). The easy adhesion layer is a layer for firmly adhering the backsheet to the sealant for encapsulating the solar cell element (hereinafter this may be referred to as a power generation element) on the cell-side substrate (cell body).

The easy adhesion layer may be formed of a binder and inorganic fine particles, and if desired, may contain any other ingredient such as additives. Preferably, the easy adhesion layer is so designed as to have an adhesion force of at least 10 N/cm (preferably at least 20 N/cm) to the ethylene-vinyl acetate (EVA, ethylene-vinyl acetate copolymer) sealant for encapsulating the power generation element on the cell-side substrate. When the adhesion force of the layer is at least 10 N/cm, then the wet heat resistance capable of securing the adhesiveness thereof is easy to better.

The adhesion force may be controlled according to a method of controlling the amount of the binder and the inorganic fine particles in the easy adhesion layer, or according to a method of corona-treating the surface of the layer on the side thereof to be adhered to the sealant of the backsheet.

The easy adhesion layer may contain at least one binder.

Preferred examples of the binder to be in the layer include, for example, polyesters, polyurethanes, acrylic resins, polyolefins, etc. Above all, preferred are acrylic resins and polyolefins from the viewpoint of the durability thereof. As the acrylic resin, also preferred is a composite resin of acryl and silicone.

Preferred examples of the binder are mentioned below. Examples of the polyolefins are Chemipearl S-120, S-75N (both by Mitsui Chemical. Examples of the acrylic resins are Jurymer ET-410, SEK-301 (both by Nippon Junyaku Kogyo). Examples of the composite resin of acryl and silicone are Ceranate WSA1060, WSA1070 (both by DIC), and H7620, H7630, H7650 (all by Asahi Kasei Chemicals).

The amount of the binder to be in the easy adhesion layer is preferably within a range of from 0.05 to 5 g/m², more preferably from 0.08 to 3 g/m². When the amount of the binder is less than 0.05 g/m², then the layer could not have the desired adhesion force; and when more than 5 g/m², then the surface planarity of the layer may worsen.

The easy adhesion layer may contain at least one type of inorganic fine particles.

As the inorganic fine particles, there may be mentioned silica, calcium carbonate, magnesium oxide, magnesium carbonate, tin oxide, etc. Of those, preferred are fine particles of tin oxide or silica from the viewpoint that the reduction in the adhesiveness of the layer is small when exposed to wet heat environments.

Preferably, the particle size of the inorganic fine particles is from 10 to 700 nm or so, more preferably from 20 to 300 nm or so, in terms of the volume-average particle size thereof. Using the inorganic fine particles of which the particle size falls within the range, the layer secures good easy adhesiveness. The particle size is a value measured with a laser analytic scattering particle sizer LA950 (by Horiba Corporation).

The shape of the inorganic fine particles is not specifically defined. For example, the particles may be spherical, amorphous or acicular.

The amount of the inorganic fine particles to be in the easy adhesion layer is preferably from 5 to 400% by mass of the binder in the layer. When the amount of the inorganic fine particles is less than 5% by mass, then the layer could not secure good adhesiveness when exposed to wet heat environments; and when more than 400% by mass, then the surface planarity of the easy adhesion layer may worsen. In particular, the content of the inorganic fine particles is more preferably within a range of from 50 to 300% by mass.

The easy adhesion layer may contain at least one crosslinking agent.

Examples of the crosslinking agent preferred for the easy adhesion layer are epoxy-type, isocyanate-type, melamine-type, carbodiimide-type and oxazoline-type crosslinking agents. From the viewpoint of securing the adhesiveness after aged in wet heat environments, oxazoline-type crosslinking agents are more preferred of these.

The amount of the crosslinking agent to be in the easy adhesion layer is preferably from 5 to 50% by mass of the binder in the layer, more preferably from 20 to 40% by mass. When the amount of the crosslinking agent is at least 5% by mass, then the agent secures a good crosslinking effect and secures good strength and adhesiveness to the colorant layer; and when at most 50% by mass, then the pot life of the coating liquid can be kept long.

If desired, a known mat agent such as polystyrene, polymethyl methacrylate, silica or the like, and a known surfactant such as an anionic surfactant or a nonionic surfactant may be added to the easy adhesion layer in the invention.

For forming the easy adhesion layer, there may be employed a method of sticking an adhesive polymer sheet to the substrate in the invention, or a method of coating the substrate with the sheet. The coating method is preferred as simple and as capable of forming a uniform and thin layer. For the coating method, for example, employable is any known method with a gravure coater or a bar coater. The solvent for the coating liquid may be water or may be an organic solvent such as toluene or methyl ethyl ketone. One or more different types of solvents may be used here either singly or as combined.

Not specifically defined, the thickness of the easy adhesion layer is generally preferably from 0.05 to 8 µm, more preferably from 0.1 to 5 µm. When the thickness of the easy adhesion layer is at least 0.05 µm, the layer readily obtains the necessary adhesiveness; and when at most 8 µm, then the surface planarity of the sheet can be kept good.

Preferably, the easy adhesion layer in the invention is transparent from the viewpoint of not reducing the effect of the colorant layer.

### <Physical Properties of Solar Cell Protective Sheet>

In the solar cell protective sheet of the invention, in case where a white pigment is added to the colorant layer to be a reflection layer, the light reflectivity at 550 nm of the sheet on the side on which the colorant layer and the easy adhesion layer are formed is preferably at least 75%. The light reflectivity is the ratio of the quantity of light that has entered the sheet from the surface of the easy adhesion layer, then reflected on the reflection layer and thereafter has gone out through the easy adhesion layer, to the quantity of the incident light. In this, as the light of a typical wavelength, employed is a light having a wavelength of 550 nm.

When the light reflectivity is at least 75%, then the light having come into the inside of the sheet, after having passed through the cell therein, can be effectively returned back to the cell, and therefore the effect of increasing the power generation efficiency is large. By controlling the colorant content to fall within a range of from 2.5 to 8.5 g/m², the light reflectivity can be controlled to be at least 75%.

Preferably, the solar cell protective sheet of the invention is such that, when it is stored in an atmosphere at 120°C and at a relative humidity of 100% for 48 hours, and then stored in an atmosphere at 130°C and at a relative humidity of 100% for 240 hours, its adhesiveness to the sealant is at least 75% of the original adhesiveness thereof before stored to the sealant. In case where the solar cell protective sheet of the invention is used as a solar cell backsheet, it preferably has, as described above, the easy adhesion layer containing a binder and inorganic fine particles in a preferable amount relative to the binder and having an adhesion force of at least 10 N/cm to the EVA sealant, from the viewpoint that the sheet can secure, even after stored under the condition as above, the adhesive force of at least 75% of the original adhesive force thereof before stored. Accordingly, the solar cell module produced herein can be protected from peeling of the backsheet and from reduction in the power generation capability owing to the peeling, and can therefore secure more improved long-term durability.

### [Method for Producing Solar Cell Protective Sheet]

The method for producing the solar cell protective sheet of the invention comprises surface-treating at least one surface of a polymer substrate, and applying a coating liquid containing a composite polymer onto the surface-treated surface of the polymer substrate so that the thickness thereof after drying could be from 0.8 µm to 12 µm, wherein the composite polymer contains a polysiloxane structural unit represented by the following formula (1) and a non-polysiloxane structural unit in the molecule: 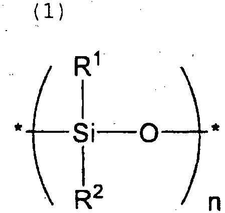 wherein R¹ and R² each independently represent a hydrogen atom, a halogen atom or a monovalent organic group; n indicates an integer of 1 or more; R¹ and R² may be the same or different; when n is 2 or more, plural R¹'s may be the same or different, and plural R²'s may be the same or different.

For the surface treatment, herein usable is the method described above.

For forming the composite polymer-containing polymer layer, employable is a method of sticking'a polymer sheet to the polymer substrate, a method of forming the polymer layer through coextrusion in the formation of the polymer substrate, a method of forming the layer by coating, or the like. Above all, the coating method is preferred as simple and as capable of forming a uniform and thin layer. For the coating method, for example, employable is any known method with a gravure coater or a bar coater.

The coating liquid for the composite polymer-containing polymer layer may be a water-base liquid where water is used as the coating solvent, or a solvent-base liquid where an organic solvent such as toluene or methyl ethyl ketone is used. Above all, from the viewpoint of the environmental load in the coating method, water is preferably used as the solvent. One or more different types of solvents may be used here either singly or as combined.

Preferably, the coating liquid for the composite polymer-containing polymer layer is a water-base coating liquid where water accounts for at least 50% by mass, more preferably at least 60% by mass of the solvent therein. The water-base coating liquid is preferred from the viewpoint of the environmental load in the coating method, and when the proportion of water in the liquid is at least 50% by mass, it is more advantageous since the environmental load may be reduced more. The proportion of water in the polymer layer coating liquid is preferably larger from the viewpoint of the environmental load, and more preferably, the water content is at least 90% by mass of all the solvent in the coating liquid.

In the method for producing the solar cell protective sheet of the invention, preferably, the composite polymer-containing coating liquid contains a crosslinking agent from the viewpoint that the composite polymer-containing polymer layer in the produced solar cell protective sheet can have a crosslinked structure to thereby enhance the wet heat durability of the sheet. Various crosslinking agents mentioned hereinabove for use in the above-mentioried colorant layer are favorably used in the coating liquid.

### [Backsheet for Solar Cell]

Preferably, the solar cell protective sheet of the invention is used as the backsheet for solar cell. In this case, more preferably, at least one, composite polymer-containing polymer layer in the solar cell protective sheet of the invention is a light-reflective layer containing a white pigment.

### (Production of Backsheet)

The solar cell backsheet of the invention may be produced in any method capable of forming the above-mentioned composite polymer-containing polymer layer and optionally the easy adhesion layer on the polymer substrate, as described above. In the invention, the backsheet may be favorably produced according to the method that comprises applying the above-mentioned coating liquid for the composite polymer-containing polymer layer (and optionally the easy adhesion layer coating liquid and others) onto the polymer substrate.

The above-mentioned coating liquid for the composite polymer-containing polymer layer is a coating liquid that contains at least a composite polymer, as described above. The details of the polymer substrate, and the composite polymer and other ingredients constituting various coating liquids are as described above.

The preferred coating method is also as described above, and for example, a gravure coater or a bar coater may be used. In the coating step in the invention, the polymer layer coating liquid may be applied onto the surface of the polymer substrate directly or via an undercoat layer having a thickness of at most 2 µm, thereby forming the polymer layer (for example, colorant layer (preferably reflection layer) or back layer) on the polymer substrate.

### Solar Cell Module

The solar cell module of the invention is characterized by containing at least one solar cell protective sheet.

The solar cell module of the invention comprises a transparent front substrate on the sunlight incident side thereof, a cell side substrate on which the solar cell element is encapsulated with a sealant, and a solar cell backsheet so arranged on the cell side substrate as to be opposite to the front substrate and to be in contact with the sealant, and preferably comprises the solar cell protective sheet of the invention or the solar cell backsheet of the invention as the solar cell backsheet therein.

As a concrete configuration of the solar cell module of the invention, for example, it is desirable that, in the solar cell module, the solar cell element having the function of converting sunlight energy into electric energy is arranged between the sunlight-incident transparent substrate and the above-mentioned solar cell backsheet of the invention, and the solar cell element is encapsulated and sealed up between the substrate and the backsheet with a sealant such as ethylene-vinyl acetate resin.

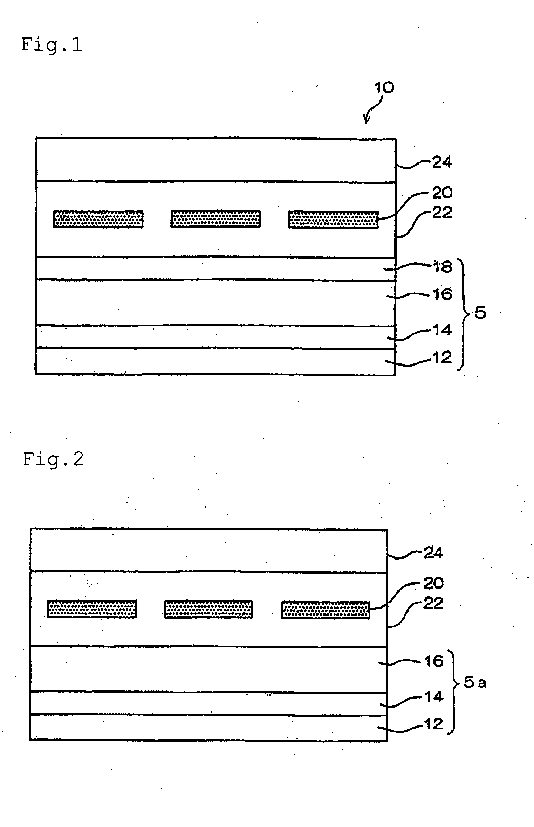

For example, Fig. 1 schematically shows one example of the configuration of a module that comprises a solar cell protective sheet. The solar cell module 10 is so designed that the solar cell element 20 for converting sunlight energy into electric energy is arranged between the sunlight-incident transparent substrate 24 and the backsheet 25, and the space between the substrate 24 and the backsheet 5 are encapsulated and sealed up with the ethylene-vinyl acetate sealant 22. The backsheet 5 in this embodiment is so designed that, on one side of the polymer substrate 16, the first polymer layer 14 and the second polymer layer 12 to be adjacent to the polymer layer 14 are formed in that order from the side of the substrate, and on the other side thereof (on the sunlight-incident side of the support), an additional layer, white reflection layer 18 is formed. In the solar cell module 10 having the illustrated configuration, a laminate structure, in which the first polymer layer containing an ultraviolet absorbent (UV absorbent) is protected with the second polymer layer containing a binder polymer as the main ingredient but not substantially containing a UV absorbent, is formed on the back side opposite to the sunlight-incident side of the module; and therefore, even when aged for a long period of time, the module is prevented from cracking and can secure good interfacial adhesiveness between the substrate and the coating layers, and the module is free from a risk of layer peeling and can secure excellent long-term durability. Accordingly, the module can be stably used for a long period of time even in the open air.

The other parts than solar cell module, solar cell unit and backsheet are described in detail, for example, in "Solar Power System Constitutive Materials" (supervised by Eiichi Sugimoto, published by Kogyo Chosakai Publishing, 2008).

The transparent substrate may be any one having sunlight permeability, and can be suitably selected from light-transmissive materials. From the viewpoint of the power generation efficiency thereof, preferred are those having a higher light transmittance; and as the substrate of the type, for example, preferably used are glass substrates, transparent resins such as acrylic resins, etc. If desired, the solar cell protective sheet of the invention may be used as the transparent substrate.

For the solar cell element, herein employable are various known solar cell elements, for example, silicon-based elements such as single-crystal silicon, polycrystalline silicon, amorphous silicon; III-V group or II-VI Group compound semiconductor-based elements such as copper-indium-gallium-selenium, copper-indium-selenium, cadmium-tellurium, gallium-arsenic, etc.

### EXAMPLES

The characteristics of the invention are described more concretely with reference to the following Examples.

In the following Examples, the material used, its amount and ratio, the details of the treatment and the treatment process may be suitably modified or changed. Accordingly, the invention should not be limitatively interpreted by the Examples mentioned below.

Unless otherwise specifically indicated, "part" is by mass.

In the following, the volume-average particle size was measured using a laser analytic scattering particle sizer LA950 (by Horiba).

### (Synthesis of Composite Polymer)

### [Synthesis Example 1] Synthesis of Composite Polymer Aqueous Dispersion P-1:

### [Step 1]

81 parts of propylene glycol mono-n-propyl ether (PNP), 360 parts of isopropyl alcohol (IPA), 110 parts of phenyltrimethoxysilane (PTMS) and 71 parts of dimethyldimethoxysilane (DMDMS) were fed into a reactor equipped with a stirrer and a dropping funnel and purged with nitrogen gas, and heated up to 80°C with stirring in a nitrogen gas atmosphere.

### [Step 2]

Next, a mixture of 260 parts of methyl methacrylate (MMA), 200 parts of n-butyl methacrylate (BMA), 110 parts of n-butyl acrylate (BA), 30 parts of acrylic acid (AA), 19 parts of 3-methacryloyloxypropyltrimethoxysilane (MPTMS), 31.5 parts of tert-butyl peroxy-2-ethylhexanoate (TBPO) and 31.5 parts of PNP was dropwise added to the reactor at the same temperature, taking 4 hours. Subsequently, this was stirred under heat at the same temperature for 2.5 hours to give a solution of an acrylic polymer having a carboxyl group and a hydrolyzable silyl group and having a weight-average molecular weight of 29,300.

### [Step 3]

Next, 54.8 parts of deionized water was added thereto, and continuously stirred under heat for 16 hours to hydrolyze the alkoxysilane, and was further condensed with the acrylic polymer to give a solution of a composite polymer having a nonvolatile fraction (NV) of 56.3% by mass and a solution acid value of 22.3 mg KOH/g, and having a carboxyl group-containing acrylic polymer-derived structural unit and a polysiloxane structural unit.

### [Step 4]

Next, 42 parts of triethylamine, was added to the solution with stirring at the same temperature, and stirred for 10 minutes. Accordingly, 100% of the contained carboxyl group was thereby neutralized.

### [Step 5]

Subsequently, 1250 parts of deionized water was dropwise added thereto at the same temperature for phase conversion emulsification, taking 1.5 hours, and then heated up to 50°C and stirred for 30 minutes. Next, a part of water was removed under reduced pressure along with the organic solvent at an internal temperature of 40°C, taking 3.5 hours.

In that manner, an aqueous dispersion P-1 of a composite polymer having a solid concentration of 42% by mass and a mean particle size of 110 nm, and having a polysiloxane structural unit and a carboxyl group-containing acrylic polymer-derived structural unit. In the aqueous dispersion P-1, polysiloxane structural unit accounts for about 25%, and the acrylic polymer structural unit accounts for about 75%.

### [Synthesis Example 2 to Synthesis Example 5] Synthesis of Composite Polymer Aqueous Dispersions P-2 to P-5:

Composite polymer aqueous dispersions P-2 to P-5, which differ from each other in point of the proportion of the polysiloxane structural unit in one molecule of the composite polymer therein, were produced in the same manner as in Production Example 1 except that the monomer amount to be used in production of the composite polymer aqueous dispersion P-1 was changed to that indicated in Table 1.

### [Synthesis Example 6] Synthesis of Composite Polymer Aqueous Dispersion P-6:

A composite polymer aqueous dispersion P-6 was produced in the same manner as that for production of the composite polymer aqueous dispersion P-1 except that 110 parts of phenyltrimethoxysilane (PTMS) and 71 parts of dimethyldimethoxysilane (DMDMS) to be added first in production of the composite polymer aqueous dispersion P-1 were changed to 100 parts of phenyltrimethoxysilane (PTMS), 10 parts of 3-aminopropyltriethoxysilane (APTES) and 71 parts of dimethyldimethoxysilane (DMDMS).

In the aqueous dispersion P-6, the polysiloxane structural unit accounts for about 25% and the acrylic polymer structural unit accounts for about 75%.

### [Synthesis Example 7] Synthesis of Composite Polymer Aqueous Dispersion P-7:

A composite polymer aqueous dispersion P-7 was produced in the same manner as that for production of the composite polymer aqueous dispersion P-6 except that 10 parts of 3-aminopropyltriethoxysilane (APTES) in production of the composite polymer aqueous dispersion P-6 was changed to 10 parts of 3-mercaptopropyltrimethoxysilane (MPTMS).

In the aqueous dispersion P-7, the polysiloxane structural unit accounts for about 25% and the acrylic polymer structural unit accounts for about 75%.

### [Synthesis Example 8] Synthesis of Composite Polymer Aqueous Dispersion P-8:

A composite polymer aqueous dispersion P-8 was produced in the same manner as that for production of the composite polymer aqueous dispersion P-6 except that 10 parts of 3-aminopropyltriethoxysilane (APTES) in production of the composite polymer aqueous dispersion P-6 was changed to 10 parts of 3-glycidoxypropyltrimethoxysilane (GPTMS).

In the aqueous dispersion P-8, the polysiloxane structural unit accounts for about 25% and the acrylic polymer structural unit accounts for about 75%.

### [Synthesis Example 9] Synthesis of Composite Polymer Aqueous Dispersion P-9:

A composite polymer aqueous dispersion P-9 was produced in the same manner as that for production of the composite polymer aqueous dispersion P-6 except that 10 parts of 3-aminopropyltriethoxysilane (APTES) in production of the composite polymer aqueous dispersion P-6 was changed to 10 parts of p-styryltrimethoxysilane (STMS).

In the aqueous dispersion P-9, the polysiloxane structural unit accounts for about 25% and the acrylic polymer structural unit accounts for about 75%.

The ratio of the starting materials fed in producing the composite polymer aqueous dispersions P-1 to P-9 is shown in Table 1 below.

**Table 1**

| | Starting Material | Synthesis Example 1 | Synthesis Example 2 | Synthesis Example 3 | Synthesis Example 4 | Synthesis Example 5 | Synthesis Example 6 | Synthesis Example 7 | Synthesis Example 8 | Synthesis Example 9 |
|---|---|---|---|---|---|---|---|---|---|---|
| | | P-1 | P-2 | P-3 | P-4 | P-5 | P-6 | P-7 | P-8 | P-9 |
| [Step 1] | PNP | 81 | 81 | 81 | 81 | 81 | 81 | 81 | 81 | 81 |
| | IPA | 360 | 360 | 360 | 360 | 360 | 360 | 360 | 360 | 360 |
| | PTMS | 110 | 210 | 350 | 60 | 360 | 100 | 100 | 100 | 100 |
| | DMDMS | 71 | 166 | 290 | 25 | 300 | 71 | 71 | 71 | 71 |
| | APTES | | | | | | 10 | | | |
| | MPTMS | | | | | | | 10 | | |
| | GPTMS | | | | | | | | 10 | |
| | STMS | | | | | | | | | 10 |
| [Step 2] | MMA | 260 | 200 | 50 | 300 | 40 | 260 | 260 | 260 | 260 |
| | BMA | 200 | 100 | 30 | 220 | 20 | 200 | 200 | 200 | 200 |
| | BA | 110 | 70 | 10 | 150 | 10 | 110 | 110 | 110 | 110 |
| | AHA | 30 | 30 | 30 | 30 | 30 | 30 | 30 | 30 | 30 |
| | MPTMS | 19 | 24 | 40 | 15 | 40 | 19 | 19 | 19 | 19 |
| | TBPO | 31.5 | 31.5 | 31.5 | 31.5 | 31.5 | 31.5 | 31.5 | 31.5 | 31.5 |
| | PNP | 31.5 | 31.5 | 31.5 | 31.5 | 31.5 | 31.5 | 31.5 | 31.5 | 31.5 |
| [Step 3] | Deionized Water | 54.8 | 54.8 | 54.8 | 54.8 | 54.8 | 54.8 | 54.8 | 54.8 | 54.8 |
| [Step 4] | TEA | 42 | 42 | 42 | 42 | 42 | 42 | 42 | 42 | 42 |
| [Step 5] | Deionized Water | 1250 | 1250 | 1250 | 1250 | 1250 | 1250 | 1250 | 1250 | 1250 |
| Molecular Structure of Composite Polymer | polysiloxane structural unit | 25% | 50% | 85% | 13% | 87% | 25% | 25% | 25% | 25% |
| | acrylic polymer structural unit | 75% | 50% | 15% | 87% | 13% | 75% | 75% | 75% | 75% |

### (Production of Polymer Substrate)

### [Production Example 1] Production of PET-1:

### [Step 1] -Esterification-

A slurry of 100 kg of high-purity terephthalic acid (by Mitsui Chemical) and 45 kg of ethylene glycol (by Nippon Shokubai) was sequentially fed into an esterification tank previously charged with about 123 kg of bis(hydroxyethyl) terephthalate and kept at a temperature of 250°C and a pressure of 1.2 × 10⁵ Pa, taking 4 hours, and after the addition, this was further esterified for 1 hour. Subsequently, 123 g of the thus-obtained esterification product was transferred into a polycondensation tank.

### [Step 2] -Production of Polymer Pellets-

Subsequently, ethylene glycol was added to the polycondensation tank in which the esterification product had been transferred, in an amount of 0.3% by mass of the polymer to be obtained. After this was stirred for 5 minutes, an ethylene glycol solution of cobalt acetate and manganese acetate was added thereto in an amount of 30 ppm and 15 ppm, respectively, of the polymer to be obtained. Further, this was stirred for 5 minutes, and then an ethylene glycol solution of 2% by mass of a titanium alkoxide compound was added thereto in an amount of 5 ppm of the polymer to be obtained. After 5 minutes, an ethylene glycol solution of 10% by mass of ethyl diethylphosphonoacetate was added thereto in an amount of 5 ppm of the polymer to be obtained. Next, with stirring the lower polymer at 30 rpm, the reaction system was gradually heated from 250°C up to 285°C and the pressure was lowered to 40 Pa. The time to the final temperature and that to the final pressure were both 60 minutes. At the time when the stirring torque reached a predetermined level, the reaction system was purged with nitrogen, its pressure was restored to normal pressure and the polycondensation reaction was thereby stopped. With that, the product was strandwise jetted out into cold water, immediately cut into polymer pellets (diameter, about 3 mm; length, about 7 mm). The time from the start of pressure reduction to the reach to the predetermined stirring torque was 3 hours.

The titanium alkoxide compound used here is the titanium alkoxide compound (Ti content = 4.44% by mass) produced in Example 1 in Paragraph [0083] in JP-A 2005-340616.

### [Step 3] -Production of Filmy Polymer Substrate-

The pellets produced in the step 2 were melted at 280°C and cast onto a metal drum to form thereon an unstretched film having a thickness of about 3 mm. Subsequently, this was stretched in the machine direction by 3 times at 90°C, and further in the cross direction by 3.3 times at 120°C. In that manner, a filmy polymer substrate of a biaxially-stretched polyethylene terephthalate having a thickness of 300 µm (hereinafter referred to as "PET-1") was-produced.

The carboxyl group content of PET-1 was 30 equivalent/t.

### [Production Example 2] Production of PET-2:

A polymer substrate PET-2 was produced in the same manner as that for PET-1 except that the pellets obtained in the step 2 in the production of PET-1 were processed in the following solid-phase polymerization step, and then processed in the step 3.

The carboxyl group content of PET-2 was 15 equivalent/t.

### <Solid-Phase Polymerization Step>

The polymer pellets were put in a vacuum chamber kept at 40 Pa, and left therein at a temperature of 220°C for 30 hours for solid-phase polymerization.

### [Production Example 3] Production of PET-3:

A polymer substrate PET-3 was produced in the same manner as that for PET-1 except that the melting temperature in forming the biaxially-stretched film in the step 3 in the production of PET-1 was changed from 280°C to 295°C.

The carboxyl group content of PET-3 was 41 equivalent/t.

### [Production Example 4] Production of PET-4:

A polymer substrate PET-4 was produced in the same manner as that for PET-1 except that the melting temperature in forming the biaxially-stretched film in the step 3 in the production of PET-1 was changed from 280°C to 310°C.

The carboxyl group content of PET-4 was 53 equivalent/t.

### (Preparation of White Pigment Dispersion)

The following ingredients (i) to (iv) were mixed, and the mixture was dispersed for 1 hour using a Dyno Mill-type disperser.

### <Ingredients of White Pigment Dispersion>

(i) Titanium dioxide (volume-average particle size = 0.42 µm) (Taipake R-780-2 by Ishihara Sangyo, having a solid content of 100% by mass) 39.9% by mass
(ii) Polyvinyl alcohol (PVA-105 by Kuraray, having a solid content of 10% by mass) 8.0% by mass
(iii) Surfactant (Demol EP by Kao, having a solid content of 25% by mass) 0.5% by mass
(iv) Distilled water 51.6% by mass

### (Example 1)

### <Reflection Layer>

### -Preparation of Reflection Layer Coating Liquid 1-

The following ingredients (i) to (v) were mixed to prepare a reflection layer coating liquid 1 that contains a polysiloxane structural unit-containing composite polymer.

### <Composition of Reflection Layer Coating Liquid 1>

(i) White pigment dispersion mentioned above 80.0 parts
(ii) Composite polymer aqueous dispersion P-1 (having a solid concentration of 42% by mass) 13.7 parts
(iii) Polyoxyalkylene alkyl ether (Naroacty CL95 by Sanyo Chemical Industry, having a solid content of 1% by mass) 3.0 parts
(iv) Oxazoline compound (crosslinking agent) (Epocross WS-700 by Nippon Shokubai, having a solid content of 25% by mass) 2.0 parts
(v) Distilled water 13.3 parts

### -Formation of Reflection Layer-

The above-mentioned PET-1 was plasma-treated at atmospheric pressure on both sides thereof under the condition mentioned below, and the above-mentioned reflection layer coating liquid 1 was applied onto the surface-treated PET-1 and dried at 180°C for 1 minute thereby forming thereon a white pigment layer of a reflection layer (white layer) having a dry thickness of 10 µm, containing a polysiloxane structural unit-containing composite polymer and having a titanium dioxide content of 6.5 g/m².

### [Atmospheric Pressure Plasma Treatment Condition]

The surfaces of PET-1 were irradiated with plasma for 15 seconds at a plasma intensity of 250 W·min/m², as generated by a high-frequency discharge apparatus having a power source frequency of 5 kHz in a plasma gas (gas pressure: 750 Torr) atmosphere of an air/argon gas mixture, while conveyed through the apparatus.

### <Easy Adhesion Layer>

### -Preparation of Easy Adhesion layer Coating Liquid-

The following ingredients (i) to (v) were mixed to prepare an easy adhesion layer coating liquid not containing a polysiloxane structural unit-containing composite polymer.

### <Composition of Easy Adhesion Layer Coating Liquid>

(i) Polyolefin resin aqueous dispersion (binder: Chemipearl S-75N by Mitsui Chemical, having a solid content of 24% by mass) 5.2 parts
(ii) Polyoxyalkylene alkyl ether (Naroacty CL95 by Sanyo Chemical Industry, having a solid content of 1% by mass) 7.8 parts
(iii) Oxazoline compound (crosslinking agent) (Epocross WS-700 by Nippon Shokubai, having a solid content of 25% by mass) 0.8 parts
(iv) Silica fine particles aqueous dispersion (Aerosil OX-50 by Nippon Aerosil, volume-average particle size = 0.15 µm, having a solid content of 10% by mass) 2.9 parts
(v) Distilled water 83.3 parts

### -Formation of Easy Adhesion Layer-

The obtained easy adhesion layer coating liquid was applied onto the above-mentioned reflection layer so that the binder amount in the coating layer could be 0.09 g/m², and then dried at 180°C for 1 minute to thereby form thereon an easy adhesion layer not containing a polysiloxane structural unit-containing composite polymer.

### <Back layer>

### -Preparation of Back Layer Coating Liquid 1-

The following ingredients (i) to (iv) were mixed to prepare a back layer coating liquid containing a polysiloxane structural unit-containing composite polymer.

### <Composition of Back Layer Coating Liquid 1>

(i) Composite polymer aqueous dispersion P-1 (binder, having a solid concentration of 42% by mass) 45.9 parts
(ii) Oxazoline compound (crosslinking agent) (Epocross WS-700 by Nippon Shokubai, having a solid content of 25% by mass) 7.7 parts
(iii) Polyoxyalkylene alkyl ether (Naroacty CL95 by Sanyo Chemical Industry, having a solid content of 1% by mass)] 2.0 parts
(iv) Distilled water 44.4 parts

### -Formation of Back Layer-

The obtained back layer coating liquid 1 was applied onto the above-mentioned PET-1 on the side thereof on which the reflection layer and the easy adhesion layer were not formed, so that the binder amount in the coating layer could be 3.0 g/m², and then dried at 180°C for 1 minute to thereby form thereon back layer containing a polysiloxane structural unit-containing composite polymer and having a dry thickness' of 3 µm.

The above process gave a backsheet of Example 1.

### (Example 2)

A backsheet was produced in the same manner as in Example 1 except that the surface treatment given to both surfaces of the polymer substrate PET-1 was changed to low-pressure plasma treatment under the condition mentioned below.

### [Low-Pressure Plasma Treatment Condition]

The surfaces of PET-1 were irradiated with plasma for 15 seconds at an intensity of 1000 W-min/m², as generated by a high-frequency discharge apparatus at 3.56 kHz in a plasma gas (gas pressure: 1.5 Torr) atmosphere of an oxygen gas/argon gas mixture of 80/20, while conveyed through the apparatus.

### (Example 3)

A backsheet was produced in the same manner as in Example 1 except that the surface treatment given to both surfaces of the polymer substrate PET-1 was changed to flame treatment under the condition mentioned below.

### [Flame Treatment Condition]

While conveyed, the surfaces of PET-1 were exposed to flame for 0.5 seconds, as generated by combustion of a propane gas/air mixture of 1/17 (by volume), using a horizontally-long burner.

### (Example 4)

A backsheet was produced in the same manner as in Example 1 except that the surface treatment given to both surfaces of the polymer substrate PET-1 was changed to ultraviolet treatment under the condition mentioned below.

### [Ultraviolet Treatment Condition]

While conveyed, the surfaces of PET-1 were exposed to ultraviolet rays for 20 seconds under atmospheric pressure, as generated by a low-pressure mercury lamp.

### (Example 5)

A backsheet was produced in the same manner as in Example 1 except that the composite polymer aqueous dispersion P-1 used in preparing the back layer coating liquid in Example 1 was changed to the above-mentioned composite polymer aqueous dispersion P-2.

### (Example 6)

A backsheet was produced in the same manner as in Example 1 except that the composite polymer aqueous dispersion P-1 used in preparing the back layer coating liquid in Example 1 was changed to the above-mentioned composite polymer aqueous dispersion P-3.

### (Example 7)

A backsheet was produced in the same manner as in Example 1 except that the composite polymer aqueous dispersion P-1 used in preparing the back layer coating liquid in Example 1 was changed to the above-mentioned composite polymer aqueous dispersion P-4.

### (Example 8)

A backsheet was produced in the same manner as in Example 1 except that the.composite polymer aqueous dispersion P-1 used in preparing the back layer coating liquid in Example 1 was changed to the above-mentioned composite polymer aqueous dispersion P-5.

### (Example 9)

A backsheet was produced in the same manner as in Example 1 except that the composite polymer aqueous dispersion P-1 used in preparing the back layer coating liquid in Example 1 was changed to the following composite polymer aqueous dispersion P-10.
P-10: Ceranate WSA1070 (having a polysiloxane structure unit content of about 30% and an acrylic polymer structural unit content of about 70%, by DIC)

### (Example 10)

A backsheet was produced in the same manner as in Example 1 except that the composite polymer aqueous dispersion P-1 used in preparing the back layer coating liquid in Example 1 was changed to the following composite polymer aqueous dispersion P-11.
P-11: Ceranate WSA1060 (having a polysiloxane structure unit content of about 75% and an acrylic polymer structural unit content of about 25%, by DIC).

### (Example 11)

A backsheet was produced in the same manner as in Example 1 except that the composite polymer aqueous dispersion P-1 used in preparing the back layer coating liquid in Example 1 was changed to the above-mentioned composite polymer aqueous dispersion P-6.

### (Example 12)

A backsheet was produced in the same manner as in Example 1 except that the composite polymer aqueous dispersion P-1 used in preparing the back layer coating liquid in Example 1 was changed to the above-mentioned composite polymer aqueous dispersion P-7.

### (Example 13)

A backsheet was produced in the same manner as in Example 1 except that the composite polymer aqueous dispersion P-1 used in preparing the back layer coating liquid in Example 1 was changed to the above-mentioned composite polymer aqueous dispersion P-8.

### (Example 14)

A backsheet was produced in the same manner as in Example 1 except that the composite polymer aqueous dispersion P-1 used in preparing the back layer coating liquid in Example 1 was changed to the above-mentioned composite polymer aqueous dispersion P-9.

### (Example 15)

A backsheet was produced in the same manner as in Example 1 except that the crosslinking agent used in preparing the back layer coating liquid in Example 1 was changed to the following epoxy compound.
Epoxy compound (Denacol Ex521 by Nagase Chemtec, having a solid content of 25% by mass).

### (Example 16)

A backsheet was produced in the same manner as in Example 1 except that the crosslinking agent used in preparing the back layer coating liquid in Example 1 was changed to the following carbodiimide compound.
Carbodiimide compound (Carbodilite V-02-L2 by Nisshin Spinning, having a solid content of 25% by mass).

### (Example 17)

A backsheet was produced in the same manner as in Example 1 except that the crosslinking agent was not added in preparing the back layer coating liquid in Example 1.

### (Example 18)

A backsheet was produced in the same manner as in Example 1 except that the back layer coating liquid 1 in Example 1 was changed to the following white pigment-containing coating liquid 2. In the backsheet obtained in Example 18, the back layer has the same function as that of a reflection layer owing to the white pigment contained in the white pigment-containing coating liquid 2.

### (Preparation of White Pigment-Containing Coating Liquid 2)

The following ingredients (i) to (v) were mixed to prepare a white pigment-containing back layer coating liquid.

### <Ingredients of White Pigment-Containing Coating Liquid 2>

(i) Composite polymer aqueous dispersion P-1 (binder, having a solid concentration of 42% by mass) 45.9 parts
(ii) Oxazoline compound (crosslinking agent) (Epocross WS-700 by.Nippon Shokubai, having a solid content of 25% by mass) 7.7 parts
(iii) Polyoxyalkylene alkyl ether (Naroacty CL95 by Sanyo Chemical Industry, having a solid content of 1% by mass) 2.0 parts
(iv) White pigment dispersion 33.0 parts
(v) Distilled water 11.4 parts

### (Example 19)

A backsheet was produced in the same manner as in Example 18 except that the polymer substrate PET-1 in Example 18 was changed to the above-mentioned PET-2.

### (Example 20)

A backsheet was produced in the same manner as in Example 18 except that the polymer substrate PET-1 in Example 18 was changed to the above-mentioned PET-3.

### (Example 21)

A backsheet was produced in the same manner as in Example 18 except that the polymer substrate PET-1 in Example 18 was changed to the above-mentioned PET-4.

### (Comparative Example 1)

A backsheet was produced in the same manner as in Example 1 except that the polymer substrate PET-1 in Example 1 was not surface-treated on both surfaces thereof.

### (Comparative Example 2)

A backsheet was produced in the same manner as in Comparative Example 1 except that the composite polymer aqueous dispersion P-1 used in preparing the back layer coating liquid in Comparative Example 1 was changed to the following composite polymer aqueous dispersion P-101.
P-101: FINETEX Es650 (by DIC) (polyester binder not having a polysiloxane structural unit).

### (Comparative Example 3)

A backsheet was produced in the same manner as in Comparative Example 1 except that the composite polymer aqueous dispersion P-1 used in preparing the back layer coating liquid in Comparative Example 1 was changed to the following composite polymer aqueous dispersion P-102.
P-102: Olester UD350 (by Mitsui Chemical) (polyurethane binder not having a polysiloxane structural unit).

### (Comparative Example 4)

A backsheet was produced in the same manner as in Example 1 except that the composite polymer aqueous dispersion P-1 used in preparing the back layer coating liquid in Example 1 was changed to the following composite polymer aqueous dispersion P-101.
P-101: FINETEX Es650 (by DIC) (polyester binder not having a polysiloxane structural unit).

### (Comparative Example 5)

A backsheet was produced in the same manner as in Example 1 except that the composite polymer aqueous dispersion P-1 used in preparing the back layer coating liquid in Example 1 was changed to the following composite polymer aqueous dispersion P-102.
P-102: Olester UD350 (by Mitsui Chemical) (polyurethane binder not having a polysiloxane structural unit).

### (Comparative Example 6)

A backsheet was produced in the same manner as in Example 1 except that the dry thickness of the polymer layer containing the polysiloxane structural unit-having composite polymer in Example 1 was changed to 0.5 µm.

### (Comparative Example 7)

A backsheet was produced in the same manner as in Example 1 except that the dry thickness of the polymer layer containing the polysiloxane structural unit-having composite polymer in Example 1 was changed to 13 µm.

### <Evaluation Methods>

### -Evaluation of Adhesiveness-

### (1) Adhesiveness before wet heat aging:

Using a single-edged cutter, the back layer surface of the produced backsheet was cut to form 6 cuts both horizontally and vertically, thereby giving 25 cross-cut squares. A Mylar tape (polyester tape) was stuck onto it, and peeled by pulling the tape by hand in the direction of 180 degrees along the sample surface. In this, the number of the peeled cross-cut squares was counted and the adhesion force of the back layer was thereby evaluated by ranking it according to the following evaluation criteria. The evaluation ranks 4 and 5 are in an allowable range for practical use.

### <Evaluation Criteria>

5: No cross-cut square peeled (0 cross-cut square).
4: From 0 to less than 0.5 cross-cut squares peeled.
3: From 0.5 to less than 2 cross-cut squares peeled.
2: From 2 to less than 10 cross-cut squares peeled.
1: 10 or more cross-cut squares peeled.

### (2) Adhesiveness after wet heat aging (I):

The produced backsheet was kept in an environment at 120°C and at a relative humidity of 100% for 48 hours, then conditioned in an environment at 25°C and at a relative humidity of 60% for 1 hour, and thereafter the adhesion force of the back layer of the backsheet was evaluated according to the same method as that for evaluation of the above-mentioned "(1) adhesiveness before wet heat aging".

### (3) Adhesiveness after wet heat aging (II):

The produced backsheet was kept in an environment at 130°C and at a relative humidity of 100% for 240 hours, then conditioned in an environment at 25°C and at a relative humidity of 60% for 1 hour, and thereafter the adhesion force of the back layer of the backsheet was evaluated according to the same method as that for evaluation of the above-mentioned "(1) adhesiveness before wet heat aging".

### (4) Adhesiveness after dipping in water:

The produced backsheet was dipped in distilled water at 25°C for 16 hours, then water on the surface thereof was wiped off in an environment at 25°C and at a relative humidity of 60%, and immediately the adhesion force of the back layer of the backsheet was evaluated according to the same method as that for evaluation of the above-mentioned " (1) adhesiveness before wet heat aging".

### (5) Adhesiveness after exposure to ultraviolet rays (UV):

Using a Suga Test Instruments' ultra-energy irradiation tester (UE-1DEC Model), the back layer surface of the produced backsheet was exposed to 100 mW/cm² energy light having a peak wavelength in the ultraviolet region, for 48 hours, and then immediately the adhesion force of the back layer was evaluated according to the same method as that for evaluation of the above-mentioned "(1) adhesiveness before wet heat aging".

During the light irradiation, the temperature of the backsheet was kept controlled at 63°C.

The results of the adhesiveness evaluation of the above (1) to (5) of the backsheets obtained in Examples 1 to 21 and Comparative Examples 1 to 7 are shown in Table 2.

**Table 2**

| | Substrate | | | Back Layer | | | | | Back Layer Adhesiveness Evaluation | | | | |
|---|---|---|---|---|---|---|---|---|---|---|---|---|---|
| | Polymer | Carboxyl Group Content [equivalent/t] | Surface Treatment | Composite Polymer | | Crosslinking Agent | Use of White Pigment | Dry Thickness [µm] | Before Wet Heat Aging | After Wet Heat Aging (I) | After Wet Heat Aging (II) | After Dipping In Water | After UV Irradiation |
| | | | | Aqueous Dispersion No. | Polysiloxane Amount [% by mass] | | | | | | | | |
| Example 1 | PET-1 | 30 | atmospheric pressure plasma | P-1 | 25 | oxazoline | no | 3 | 5 | 5 | 5 | 5 | 4 |
| Example 2 | PET-1 | 30 | low pressure plasma | P-1 | 25 | oxazoline | no | 3 | 5 | 5 | 5 | 5 | 4 |
| Example 3 | PET-1 | 30 | flame treatment | P-1 | 25 | oxazoline | no | 3 | 5 | 5 | 5 | 5 | 4 |
| Example 4 | PET-1 | 30 | UV treatment | P-1 | 25 | oxazoline | no | 3 | 5 | 5 | 5 | 5 | 4 |
| Example 5 | PET-1 | 30 | atmospheric pressure plasma | P-2 | 50 | oxazoline | no | 3 | 5 | 5 | 5 | 5 | 4 |
| Example 6 | PET-1 | 30 | atmospheric pressure plasma | P-3 | 85 | oxazoline | no | 3 | 5 | 5 | 5 | 5 | 4 |
| Example 7 | PET-1 | 30 | atmospheric pressure plasma | P-4 | 13 | oxazoline | no | 3 | 5 | 4 | 4 | 4 | 4 |
| Example 8 | PET-1 | 30 | atmospheric pressure plasma | P-5 | 87 | oxazoline | no | 3 | 5 | 4 | 4 | 4 | 4 |
| Example 9 | PET-1 | 30 | atmosphere pressure plasma | P-10 | 30 | oxazoline | no | 3 | 5 | 5 | 5 | 5 | 4 |
| Example 10 | PET-1 | 30 | atmospheric pressure plasma | P-11 | 75 | oxazoline | no | 3 | 5 | 5 | 5 | 5 | 4 |
| Example 11 | PET-1 | 30 | atmospheric pressure plasma | P-6 | 25 | oxazoline | no | 3 | 5 | 5 | 5 | 5 | 4 |
| Example 12 | PET-1 | 30 | atmospheric pressure plasma | P-7 | 25 | oxazoline | no | 3 | 5 | 5 | 5 | 5 | 4 |
| Example 13 | PET-1 | 30 | atmospheric pressure plasma | P-8 | 25 | oxazoline | no | 3 | 5 | 5 | 5 | 5 | 4 |
| Example 14 | PET-1 | 30 | atmospheric pressure plasma | P-9 | 25 | oxazoline | no | 3 | 5 | 5 | 5 | 5 | 4 |
| Example 15 | PET-1 | 30 | atmospheric pressure plasma | P-1 | 25 | epoxy | no | 3 | 5 | 5 | 5 | 5 | 4 |
| Example 16 | PET-1 | 30 | atmospheric pressure plasma | P-1 | 25 | carbodilmide | no | 3 | 5 | 5 | 5 | 5 | 4 |
| Example 17 | PET-1 | 30 | atmospheric pressure plasma | P-1 | 25 | no | no | 3 | 4 | 4 | 4 | 4 | 4 |
| Example 18 | PET-1 | 30 | atmospheric pressure plasma | P-1 | 25 | oxazoline | yes | 3 | 5 | 5 | 5 | 5 | 5 |
| Example 19 | PET-2 | 15 | atmospheric pressure plasma | P-1 | 25 | oxazoline | yes | 3 | 5 | 5 | 5 | 5 | 5 |
| Example 20 | PET-3 | 41 | atmospheric pressure plasma | P-1 | 25 | oxazoline | yes | 3 | 5 | 4 | 4 | 4 | 5 |
| Example 21 | PET-4 | 53 | atmospheric pressure plasma | P-1 | 25 | oxazoline | yes | 3 | 5 | 4 | 4 | 4 | 5 |
| Comparative Example 1 | PET-1 | 30 | no | P-1 | 25 | oxazoline | no | 3 | 5 | 5 | 3 | 5 | 3 |
| Comparative Example 2 | PET-1 | 30 | no | P-101 | 0 | oxazoline | no | 3 | 5 | 2 | 1 | 2 | 2 |
| Comparative Example 3 | PET-1 | 30 | no | P-102 | 0 | oxazoline | no | 3 | 5 | 2 | 1 | 2 | 2 |
| Comparative Example 4 | PET-1 | 30 | atmospheric pressure plasma | P-101 | 0 | oxazoline | no | 3 | 5 | 3 | 2 | 2 | 3 |
| Comparative Example 5 | PET-1 | 30 | atmospheric pressure plasma | P-102 | 0 | oxazoline | no | 3 | 5 | 3 | 2 | 2 | 3 |
| Comparative Example 6 | PET-1 | 30 | atmospheric pressure plasma | P-1 | 25 | oxazoline | no | 0.5 | 5 | 4 | 3 | 2 | 3 |
| Comparative Example 7 | PET-1 | 30 | atmospheric pressure plasma | P-1 | 25 | oxazoline | no | 13 | 3 | 3 | 2 | 2 | 3 |

As shown in Table 2 above, it is known that, in Examples 1 to 21, the adhesiveness between the substrate and the back layer is good even after aged in wet heat environments and the backsheets produced all have good adhesion durability. Further, in Examples 1 to 21, the backsheets produced all have good adhesion durability between the substrate and the back layer even after dipped in water or after exposure to light.

In particular, in these Examples where the polymer substrate is processed for flame treatment, low-pressure plasma treatment, atmospheric plasma treatment or ultraviolet treatment and where the polysiloxane amount in the composite polymer is from 15 to 85% by mass and R¹ and R² in the composite polymer each are a monovalent organic group falling within the above-mentioned preferred range, the backsheets produced all have extremely excellent adhesion durability even after exposed to wet heat environments or after dipped in water.

In these Examples where the polymer layer containing a polysiloxane structural unit-containing composite polymer has a crosslinked structure, the backsheets produced all have extremely excellent adhesion durability even after aged in wet heat environments. In these Examples where the carboxyl group content of the polymer substrate is from 2 to 35 equivalent/t, the backsheets produced all have extremely excellent adhesion durability even after aged in wet heat environments. In these Examples where the back layer contains a white pigment, the backsheets produced all have extremely excellent adhesion durability even after UV irradiation. As opposed to these, in the backsheets in Comparative Examples 1 to 7, the adhesiveness between the substrate and the back layer worsens after aged in wet heat environments, and the backsheets do not have adhesion durability. In addition, in the backsheets in Comparative Examples 1 to 7, the adhesion durability between the substrate and the back layer is not good after dipped in water or after exposed to light. In particular, the backsheet in Comparative Example 7 where the thickness of the polymer layer containing a polysiloxane structural unit-containing composite polymer is more than the uppermost limit in the invention, the adhesion durability between the substrate and the backsheet before and after aged in wet heat environments is not good, and the adhesion durability therebetween after dipped in water or after exposed to light is also not good. In the backsheet in Comparative Example 6 where the thickness of the polymer layer containing a polysiloxane structural unit-containing composite polymer is less than the lowermost limit in the invention, the adhesiveness between the substrate and the back layer in the wet heat aging tests (I) and (II) is not good, and the adhesion durability of the backsheet is not good.

### <Production of Backsheet Having Two-Layered Back Layer>

### (Example 22)

A backsheet was produced in the same manner as in Example 1 except that, after the easy adhesion layer was formed in Example 1, a two-layered back layer containing a polysiloxane structural unit-containing composite polymer was formed in the manner mentioned below.

After the easy adhesion layer was formed in the same manner as in Example 1, a first back layer coating liquid A having the following composition and containing a polysiloxane structural unit-containing composite polymer was applied onto the side of PET-1 on which the reflection layer and the easy adhesion layer were not formed, so that the binder amount in the coating layer could be 3.0 g/m², and then dried at 180°C for 1 minute to form a first back layer having a dry thickness of 3 µm. Next, a second back layer coating liquid B having the following composition and containing a polysiloxane structural unit-containing composite polymer was applied onto the first back layer so that the binder amount in the coating layer could be 2.0 g/m², and then dried at 180°C for 1 minute to form a second back layer having a dry thickness of 2 µm.

### -Preparation of First Back Layer Coating Liquid A-

The following ingredients (i) to (v) were mixed to prepare a first back layer coating liquid A containing a polysiloxane structural unit-containing composite polymer and containing a white pigment.

### <Ingredients of First Back Layer Coating Liquid A>

(i) Composite polymer aqueous dispersion P-1 mentioned above (binder, having a solid concentration of 42% by mass) 45.9 parts
(ii) Oxazoline compound (crosslinking agent) (Epocross WS-700 by Nippon Shokubai, having a solid content of 25% by mass) 7.7 parts
(iii) Polyoxyalkylene alkyl ether (Naroacty CL95 by Sanyo Chemical Industry, having a solid content of 1% by mass) 2.0 parts
(iv) White pigment dispersion mentioned above 33.0 parts
(v) Distilled water 11.4 parts

### -Preparation of Second Back Layer Coating Liquid B-

The following ingredients (i) to (iv) were mixed to prepare a second back layer coating liquid B containing a polysiloxane structural unit-containing composite polymer but not containing a white pigment.

### <Ingredients of Second Back Layer Coating Liquid B>

(i) Composite polymer aqueous dispersion P-3 mentioned above (binder, having a solid concentration of 42% by mass) 45.9 parts
(ii) Oxazoline compound (crosslinking agent) (Epocross WS-700 by Nippon Shokubai, having a solid content of 25% by mass) 7.7 parts
(iii) Polyoxyalkylene alkyl ether (Naroacty CL95 by Sanyo Chemical Industry, having a solid content of 1% by mass) 2.0 parts
(v) Distilled water 44.4 parts

### (Examples 23 to 27)

Backsheets of Examples 23 to 27 were produced in the same manner as in Example 22 except that the composite polymer aqueous dispersion used in the first back layer and the second back layer in Example 22 was changed as in Table 3 below.

The details of P-103 are as follows:
P-103: Obbligato (by AGC COAT-TECH, fluorine-containing binder not having a polysiloxane structural unit).

The adhesiveness of the two-layered back layer of the backsheets of Examples 22 to 27 were evaluated in the same manner as in Examples 1 to 21, except that, using a single-edged cutter, the surface of the second back layer of the produced backsheet was cut to form 6 cuts all not reaching the surface of the first back layer, both horizontally and vertically, thereby giving 25 cross-cut squares. The results are shown in Table 3 below.

**Table 3**

| | Substrate | | First Back Layer | | | Second Back Layer | | | Back Layer Adhesiveness Evaluation | | | | |
|---|---|---|---|---|---|---|---|---|---|---|---|---|---|
| | Polymer | Surface Treatment | Composite Polymer | | Dry Thickness [µm] | Composite Polymer | | Dry Thickness [µm] | Before Wet Heat Aging | After Wet Heat Aging (I) | After Wet Heat Aging (II) | After Dipped in Water | After UV Irradiation |
| | | | Aqueous Dispersion No. | Polysiloxane Amount [% by mass] | | Aqueous Dispersion No. | Polysiloxane Amount [% by mass] | | | | | | |
| Example 22 | PET-1 | atmospheric pressure plasma | P-1 | 25 | 3 | P-3 | 85 | 2 | 5 | 5 | 5 | 5 | 5 |
| Example 23 | PET-1 | atmospheric pressure plasma | P-1 | 25 | 3 | P-103 | 0 | 2 | 5 | 5 | 5 | 5, | 5 |
| Example 24 | PET-1 | atmospheric pressure plasma | P-1 | 25 | 3 | P-10 | 30 | 2 | 5 | 5 | 5 | 5 | 5 |
| Example 25 | PET-1 | atmospheric pressure plasma | P-10 | 30 | 3 | P-3 | 85 | 2 | 5 | 5 | 5 | 5 | 5 |
| Example 26 | PET-1 | atmospheric pressure plasma | P-10 | 30 | 3 | P-103 | 0 | 2 | 5 | 5 | 5 | 5 | 5 |
| Example 27 | PET-1 | atmospheric pressure plasma | P-10 | 30 | 3 | P-10 | 30 | 2 | 5 | 5 | 5 | 5 | 5 |

In Table 3, the carboxyl group content of the substrate is 30 equivalent/t in every case. In forming the first back layer and the second back layer, used was an oxazoline-type crosslinking agent-containing coating liquid.

As shown in Table 3, in the backsheets of Examples 22 to 27, the adhesiveness between the substrate and the two-layered back layer is good even when exposed to wet heat environments and when dipped in water or exposed to light irradiation, and the backsheets all have excellent adhesion durability.

### <Fabrication and Evaluation of Solar Cell Module>

### (Example 28)

A hardened glass sheet having a thickness of 3 mm, an EVA sheet (Mitsui Chemical Fabro's SC50B), a crystal-type solar cell element, an EVA sheet (Mitsui Chemical Fabro's SC50B) and the backsheet produced in Example 1 were layered in that order, and using a vacuum laminator (by Nisshinbo), these were hot-pressed and sealed up with EVA. In this, the backsheet was so arranged that the easy adhesion layer thereof could be in contact with the EVA sheet. The sealing method is as follows:

### <Sealing Method>

Using a vacuum laminator, the layered structure was kept in vacuum at 128°C for 3 minutes, and then kept under pressure for 2 minutes for pre-sealing. Subsequently, in a dry oven, this was finally sealed up at 150°C for 30 minutes.

### (Examples 29 to 33)

Crystal-type solar cell modules were fabricated in the same manner as in Example 28 except that the backsheet in Example 28 was changed to the backsheet produced in any of Examples 2 to 6.

### (Examples 34 to 41)

Crystal-type solar cell modules were fabricated in the same manner as in Example 28 except that the backsheet in Example 28 was changed to the backsheet produced in any of Examples 11 to 19.

### (Examples 42 to 47)

Crystal-type solar cell modules were fabricated in the same manner as in Example 28 except that the backsheet in Example 28 was changed to the backsheet produced in any of Examples 22 to 27.

The solar cell modules fabricated in Examples 28 to 47 were tried for power generation, and all these exhibited good power generation performance as solar cells.

### <Investigation of Adhesiveness between Reflection Layer and Substrate>

In place of investigating the adhesiveness between the substrate and the back layer, the adhesiveness between the substrate and the reflection layer laminated on the surface of the substrate opposite to the back layer thereon, was investigated.

### (Example 48)

A backsheet of Example 48, in which a reflection layer having a dry thickness of 10 µm and containing a polysiloxane structural unit-containing composite polymer and an oxazoline-type crosslinking agent and a white pigment was laminated on the surface of the substrate opposite to the back layer formed thereon, was produced in the same manner as in Example 18 except that the condition of the surface treatment given to both surfaces of the polymer substrate PET-1 in Example 18 was changed to the flame treatment described in Example 3.

### (Example 49)

A backsheet was produced in the same manner as in Example 18 except that the composite polymer aqueous dispersion P-1 used in preparing the reflection layer coating liquid in Example 18 was changed to the above-mentioned composite polymer aqueous dispersion P-3.

### (Example 50)

A backsheet was produced in the same manner as in Example 18 except that the composite polymer aqueous dispersion P-1 used in preparing the reflection layer coating liquid in Example 18 was changed to the above-mentioned composite polymer aqueous dispersion P-10.

### (Example 51)

A backsheet was produced in the same manner as in Example 18 except that the composite polymer aqueous dispersion P-1 used in preparing the reflection layer coating liquid in Example 18 was changed to the above-mentioned composite polymer aqueous dispersion P-6.

### (Example 52)

A backsheet was produced in the same manner as in Example 18 except that the crosslinking agent used in preparing the reflection layer coating liquid in Example 18 was changed to the following epoxy compound.
Epoxy compound (Denacol Ex521 by Nagase Chemtec, having a solid content of 25% by mass).

### (Comparative Example 8)

A backsheet was produced in the same manner as in Example 18 except that the polymer substrate PET-1 in Example 18 was not surface-treated on both surfaces thereof.

### (Comparative Example 9)

A backsheet was produced in the same manner as in Comparative Example 6 except that the reflection layer coating liquid in Comparative Example 8 was changed to the following reflection layer coating liquid 2 prepared by mixing the following ingredients (i) to (v) and not containing a polysiloxane structural unit-containing composite polymer

### <Ingredients of Reflection Layer Coating Liquid 2>

(i) White pigment dispersion 80.0 parts
(ii) P-201, polyacrylic resin aqueous dispersion (binder, Jurymer ET410 by Nippon Pure Chemical, having a solid content of 30% by mass) (polyacrylic binder not having a polysiloxane structural unit) 19.2 parts
(iii) Polyoxyalkylene alkyl ether (Naroacty CL95 by Sanyo Chemical Industry, having a solid content of 1% by mass) 3.0 parts
(iv) Oxazoline compound (crosslinking agent) (Epocross WS-700 by Nippon Shokubai, having a solid content of 25% by mass) 2.0 parts
(v) Distilled water 7.8 parts

### (Comparative Example 10)

A backsheet was produced in the same manner as in Example 18 except that the composite polymer aqueous dispersion P-1 used in preparing the reflection layer coating liquid in Example 18 was changed to the above-mentioned composite polymer aqueous dispersion P-201.

### (Comparative Example 11)

A backsheet was produced in the same manner as in Example 18 except that the dry thickness of the polymer layer containing the polysiloxane structural unit-containing composite polymer in Example 18 was changed to 0.5 µm.

### (Comparative Example 12)

A backsheet was produced in the same manner as in Example 18 except that the dry thickness of the polymer layer containing the polysiloxane structural unit-containing composite polymer in Example 18 was changed to 13 µm.

### -Adhesiveness Evaluation-

In the produced backsheets, the adhesiveness between the sealant (EVA) and the backsheet before and after wet heat aging was evaluated according to the methods mentioned below. The evaluation results are shown in Table 4 below.

### [A] Adhesiveness before wet heat aging:

The backsheet produced in the manner as above was cut into a size of 20 mm width x 150 mm length, and two such sample pieces were prepared. The two sample pieces were put one upon another in such a manner their easy adhesion layer sides could face inside, and an EVA sheet (Mitsui Fabro's EVA sheet, SC50B) cut to have a size of 20 mm width x 100 mm length was put-between them, and hot-pressed using a vacuum laminator (by Nisshinbo) so that the two could adhere to each other via EVA. The adhesion condition in this case was as follows:
Using a vacuum laminator, the sample was kept in vacuum at 128°C for 3 minutes, and then kept under pressure for 2 minutes for pre-sealing. Subsequently, in a dry oven, this was finally sealed up at 150°C for 30 minutes. In that manner, an adhesiveness evaluation sample was prepared, in which the part of 20 mm from one edge of the adhered two pieces was not sealed up with EVA, and the remaining 100-mm part was sealed up with the EVA sheet.

The EVA-free part of the adhesiveness evaluation sample thus prepared was clipped with the upper and lower clips of Tensilon (RTC-1210A by Orientec), and the two pieces were pulled at a peeling angle of 180 degrees and at a pulling rate of 300 mm/min, and in the tensile test, the adhesion force of the sample was measured. In the tensile test, the reflection layer peeled from EVA ine very backsheet tested, but there occurred no peeling between the reflection layer and the substrate in the backsheet.

Based on the thus-measured adhesion force, the tested samples were ranked according to the following evaluation criteria. The evaluation ranks 4 and 5 are within an acceptable range for practical use.

### <Evaluation Criteria>

5: The adhesion was extremely good (60 N/20 mm or more).
4: The adhesion was good (from 30 N/20 mm to less than 60 N/20 mm).
3: The adhesion was somewhat bad (from 20 N/20 mm to less than 30 N/20 mm).
2: Adhesion failure occurred (from 10 N/20 mm to less than 20 N/20 mm).
1: Adhesion failure was remarkable (less than 10 N/20 mm).

### [B] Adhesiveness after wet heat aging (III):

The prepared adhesiveness evaluation sample was aged under an environment at 85°C and a relative humidity of 85% for 1000 hours (wet heat aging), and then its adhesion force was measured in the same manner as in the above [A]. Based on the measured adhesion force, the tested samples were ranked according to the above-mentioned evaluation criteria. The evaluation ranks 4 and 5 are within an acceptable range for practical use.

### [C] Adhesiveness after wet heat aging (IV):

The prepared adhesiveness evaluation sample was aged under an environment at 85°C and a relative humidity of 85% for 3000 hours (wet heat aging), and then its adhesion force was measured in the same manner as in the above [A]. Based on the measured adhesion force, the tested samples were ranked according to the above-mentioned evaluation criteria. The evaluation ranks 4 and 5 are within an acceptable range for practical use.

The obtained results are shown in Table 4 below.

**Table 4**

| | Substrate | | | Reflection Layer | | | | Reflection Layer Adhesiveness Evaluation | | |
|---|---|---|---|---|---|---|---|---|---|---|
| | Polymer | Carboxyl Group Content [eq./t] | Surface Treatment | Composite Polymer | | Crosslinking Agent | Dry Thickness [µm] | before wet heat aging | after wet heat aging (III) | after wet heat aging (IV) |
| | | | | Aqueous Dispersion No. | Polysiloxane Amount [% by mass] | | | | | |
| Example 18 | PET-1 | 30 | atmospheric pressure plasma | P-1 | 25 | oxazoline | 10 | 5 | 5 | 5 |
| Example 48 | PET-1 | 30 | flame | P-2 | 25 | oxazoline | 10 | 5 | 5 | 5 |
| Example 49 | PET-1 | 30 | atmospheric pressure plasma | P-3 | 85 | oxazoline | 10 | 5 | 5 | 5 |
| Example 50 | PET-1 | 30 | atmospheric pressure plasma | P-10 | 30 | oxazoline | 10 | 5 | 5 | 5 |
| Example 51 | PET-1 | 30 | atmospheric pressure plasma | P-6 | 25 | oxazoline | 10 | 5 | 5 | 5 |
| Example 52 | PET-1 | 30 | atmospheric pressure plasma | P-1 | 25 | epoxy | 10 | 5 | 5 | 5 |
| Comparative Example 8 | PET-1 | 30 | no | P-1 | 25 | oxazoline | 10 | 5 | 5 | 3 |
| Comparative Example 9 | PET-1 | 30 | no | P-201 | 0 | oxazoline | 10 | 5 | 2 | 1 |
| Comparative Example 10 | PET-1 | 30 | atmospheric pressure plasma | P-201 | 0 | oxazoline | 10 | 5 | 5 | 3 |
| Comparative Example 11 | PET-1 | 30 | atmospheric pressure plasma | P-1 | 25 | oxazoline | 0.5 | 5 | 2 | 1 |
| Comparative Example 12 | PET-1 | 30 | atmospheric pressure plasma | P-1 | 25 | oxazoline | 13 | 4 | 3 | 3 |

As shown in Table 4, in the backsheets of Examples 18 and 48 to 52, the adhesiveness between the substrate and the reflection layer and the adhesiveness between EVA and the reflection layer are both good even after exposed to wet heat environments for a long period of time, and these backsheets have excellent adhesion durability.

On the other hand, it is known that, in case where the substrate is not surface-treated or where a polymer not containing a polysiloxane structural unit is used in the reflection layer as in Comparative Examples 8 to 10, the adhesion durability worsens. It is also known that, in case where the dry thickness of the polymer layer containing the polysiloxane structural unit-containing composite polymer oversteps the range in the invention as in Comparative Examples 11 and 12, the adhesion durability also worsens.

### (Example 53)

A backsheet of Example 53 was produced as follows: PET-1 was previously processed for atmospheric plasma treatment on both surfaces thereof, then the reflection layer and the easy adhesion layer described in Example 18 were formed on one surface of the thus-treated PET-1, and after the formation of the easy adhesion layer, the two-layered back layer composed of a first back layer and a second back layer described in Example 22 was formed on the opposite surface of PET-1.

Using the backsheet, a solar cell module was fabricated in the same manner as in Example 28.

Thus fabricated, the solar cell module was tried for power generation, and exhibited good power generation performance as a solar cell.

## Claims

1. A solar cell protective sheet comprising a polymer substrate and at least one polymer layer provided on the polymer substrate, which satisfies the following condition [1] :
[1] the polymer substrate is a surface-treated polymer substrate, and
the polymer layer has a thickness of from 0.8 µm to 12 µm and contains a composite polymer, and the composite polymer contains a polysiloxane structural unit represented by the following formula (1) and a non-polysiloxane structural unit in the molecule: 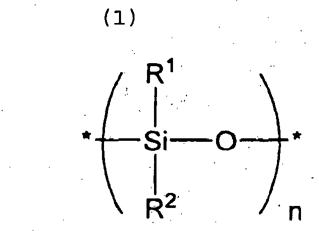 wherein R¹ and R² each independently represent a hydrogen atom, a halogen atom or a monovalent organic group; n indicates an integer of 1 or more; R¹ and R² may be the same or different; plural R¹' s may be the same or different, and plural R²_{'} s may be the same or different

2. The solar cell protective sheet according to Claim 1, wherein the surface treatment applied to the polymer substrate is at least one of flame treatment, low-pressure plasma treatment, atmospheric pressure plasma treatment and ultraviolet treatment.

3. The solar cell protective sheet according to any one of Claims 1 or 2, wherein the polysiloxane structural unit represented by the formula (1) is contained in an amount of from 15 to 85% by mass of the entire composite polymer molecule.

4. The solar cell protective sheet according to any one of Claims 1 to 3, wherein the polymer layer containing the composite polymer has a crosslinked structure.

5. The solar cell protective sheet according to any one of Claims 1 to 4, wherein the polymer substrate contains a polyester-type resin, and
the carboxyl group content of the polyester resin is from 2 to 35 equivalent/t.

6. The solar cell protective sheet according to any one of Claims 1 to 5, wherein at least one polymer layer is a light-reflective layer containing a white pigment.

7. A backsheet for solar cells, containing the solar cell protective sheet of any one of Claims 1 to 6.

8. A method for producing a solar cell protective sheet, comprising:
surface-treating at least one surface of a polymer substrate, and
applying a coating liquid containing a composite polymer onto the surface-treated surface of the polymer substrate so that the thickness thereof after drying could be from 0.8 µm to 12 µm,
wherein the composite polymer contains a polysiloxane structural unit represented by the following formula (1) and a non-polysiloxane structural unit in the molecule: 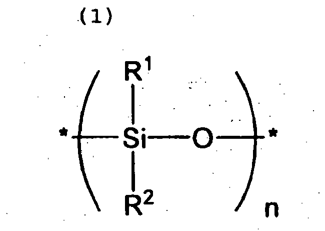 wherein R¹ and R² each independently represent a hydrogen atom, a halogen atom or a monovalent organic group; n indicates an integer of 1 or more; R¹ and R² may be the same or different; plural R¹'s may be the same or different, and plural R²'s may be the same or different.

9. A solar cell protective sheet produced according to the method for producing a solar cell protective sheet of Claim 8.

10. A solar cell module containing at least one solar cell protective sheet of any one of Claims 1 to 5.

## Patentansprüche

1. Schutzblatt für Solarzellen, umfassend ein Polymersubstrat und zumindest eine Polymerschicht, die auf dem Polymersubstrat vorgesehen ist, welches die folgende Bedingung [1] erfüllt:
[1] das Polymersubstrat ist ein oberflächenbehandeltes Polymersubstrat, und
die Polymerschicht weist eine Dicke von 0,8 _{M}m bis 12 µm auf und enthält ein Kompositpolymer, und das Kompositpolymer enthält eine durch die folgende Formel (1) dargestellte Polysiloxan-Struktureinheit und eine Nicht-Polysiloxan-Struktureinheit in dem Molekül: 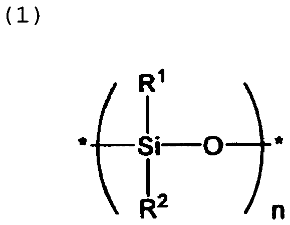 worin R¹ und R² jeweils unabhängig ein Wasserstoffatom, ein Halogenatom oder eine monovalente organische Gruppe darstellen; n eine ganze Zahl von 1 oder größer darstellt; R¹ und R² gleich oder verschieden sein können; mehrere R¹ gleich oder verschieden sein können und mehrere R² gleich oder verschieden sein können.

2. Schutzblatt für Solarzellen gemäß Anspruch 1, worin die auf das Polymersubstrat angewandte Oberflächenbehandlung mindestens eine von einer Flammbehandlung, einer Plasmabehandlung bei niedrigem Druck, einer Plasmabehandlung bei Atmosphärendruck und UV-Behandlung ist.

3. Schutzblatt für Solarzellen gemäß irgendeinem der Ansprüche 1 oder 2, worin die durch die Formel (1) dargestellte Polysiloxan-Struktureinheit in einer Menge von 15 bis 85 Masse% des gesamten Komposit-Polymermoleküls enthalten ist.

4. Schutzblatt für Solarzellen gemäß irgendeinem der Ansprüche 1 bis 3, worin die Polymerschicht, die das Kompositpolymer enthält, eine vernetzte Struktur aufweist.

5. Schutzblatt für Solarzellen gemäß irgendeinem der Ansprüche 1 bis 4, worin das Polymersubstrat ein Harz vom Polyestertyp enthält und
der Carboxylgruppengehalt des Polyesterharzes von 2 bis 35 Äquivalent/t beträgt.

6. Schutzblatt für Solarzellen gemäß irgendeinem der Ansprüche 1 bis 5, worin zumindest eine Polymerschicht eine lichtreflektierende Schicht ist, die ein weißes Pigment enthält.

7. Rückblatt für Solarzellen, enthaltend das Schutzblatt für Solarzellen gemäß irgendeinem der Ansprüche 1 bis 6.

8. Verfahren zur Herstellung eines Schutzblattes für Solarzellen, umfassend:
Oberflächenbehandeln von zumindest einer Oberfläche eines Polymersubstrats und
Auftragen einer Beschichtungsflüssigkeit, die ein Kompositpolymer enthält, auf die oberflächenbehandelte Oberfläche des Polymersubstrats, so dass dessen Dicke nach dem Trocknen von 0,8 µm bis 12 µm betragen kann,
worin das Kompositpolymer eine durch die folgende Formel (1) dargestellte Polysiloxan-Struktureinheit und eine Nicht-Polysiloxan-Struktureinheit in dem Molekül enthält: 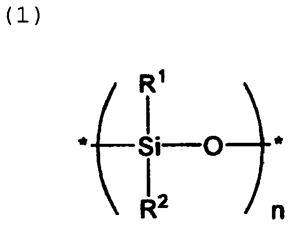 worin R¹ und R² jeweils unabhängig ein Wasserstoffatom, ein Halogenatom oder eine monovalente organische Gruppe darstellen; n eine ganze Zahl von 1 oder größer darstellt; R¹ und R² gleich oder verschieden sein können; mehrere R¹ gleich oder verschieden sein können und mehrere R² gleich oder verschieden sein können.

9. Schutzblatt für Solarzellen, hergestellt gemäß dem Verfahren zur Herstellung eines Schutzblatts für Solarzellen gemäß Anspruch 8.

10. Solarzellenmodul, enthaltend mindestens ein Schutzblatt für Solarzellen gemäß irgendeinem der Ansprüche 1 bis 5.

## Revendications

1. Feuille de protection de cellule solaire comprenant un substrat polymère et au moins une couche de polymère disposée sur le substrat polymère, qui satisfait la condition [1] suivante :
[1] le substrat polymère est un substrat polymère traité en surface, et
la couche de polymère a une épaisseur de 0,8 µm à 12 µm et contient un polymère composite, et le polymère composite contient un motif structural de polysiloxane représenté par la formule (1) suivante et un motif structurel non polysiloxane dans la molécule : 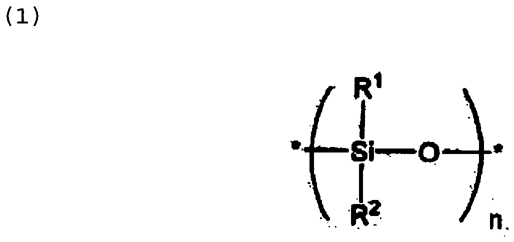 dans laquelle R¹ et R² représentent chacun indépendamment un atome d'hydrogène, un atome d'halogène ou un groupe organique monovalent ; n indique un nombre entier de 1 ou plus ; R¹ et R² peuvent être identiques ou différents ; plusieurs R¹ peuvent être identiques ou différents, et plusieurs R² peuvent être identiques ou différents.

2. Feuille de protection de cellule solaire selon la revendication 1, dans laquelle le traitement de surface appliqué au substrat polymère est au moins un traitement parmi un traitement à la flamme, un traitement par plasma à basse pression, un traitement par plasma à pression atmosphérique et un traitement ultraviolet.

3. Feuille de protection de cellule solaire selon l'une quelconque des revendications 1 ou 2, dans laquelle le motif structural polysiloxane représenté par la formule (1) est contenu dans une quantité de 15 à 85 % en masse de la molécule de polymère composite entière.

4. Feuille de protection de cellule solaire selon l'une quelconque des revendications 1 à 3, dans laquelle la couche de polymère contenant le polymère composite présente une structure réticulée.

5. Feuille de protection de cellule solaire selon l'une quelconque des revendications 1 à 4, dans laquelle le substrat polymère contient une résine de type polyester, et
la teneur en groupes carboxyle de la résine de polyester est de 2 à 35 équivalents/t.

6. Feuille de protection de cellule solaire selon l'une quelconque des revendications 1 à 5, dans laquelle au moins une couche de polymère est une couche réfléchissant la lumière contenant un pigment blanc.

7. Feuille de support pour cellules solaires, contenant la feuille de protection de cellule solaire selon l'une quelconque des revendications 1 à 6.

8. Procédé de production d'une feuille de protection de cellule solaire, comprenant :
le traitement de surface d'au moins une surface d'un substrat polymère, et
l'application d'un liquide de revêtement contenant un polymère composite sur la surface traitée en surface du substrat polymère de sorte que l'épaisseur de celui-ci après séchage pourrait être de 0,8 µm à 12 µm,
dans lequel le polymère composite contient un motif structural polysiloxane représenté par la formule (1) suivante et un motif structural non polysiloxane dans la molécule : 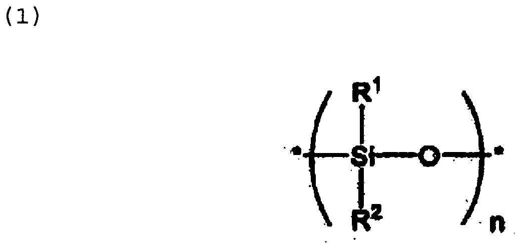 dans laquelle R¹ et R² représentent chacun indépendamment un atome d'hydrogène, un atome d'halogène ou un groupe organique monovalent ; n indique un nombre entier de 1 ou plus ; R¹ et R² peuvent être identiques ou différents ; plusieurs R¹ peuvent être identiques ou différents, et plusieurs R² peuvent être identiques ou différents.

9. Feuille de protection de cellule solaire produite selon le procédé de production d'une feuille de protection de cellule solaire selon la revendication 8.

10. Module de cellule solaire contenant au moins une feuille de protection de cellule solaire selon l'une quelconque des revendications 1 à 5.
